(19) Europäisches Patentamt
European Patent Office
Office européen des brevets

(11) EP 1 443 362 A2

(12) EUROPEAN PATENT APPLICATION

(43) Date of publication:
**04.08.2004 Bulletin 2004/32**

(51) Int Cl.[7]: **G03F 7/039**, G03F 7/023, G03F 7/022, G03F 7/004

(21) Application number: **04000825.2**

(22) Date of filing: **16.01.2004**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **17.01.2003 JP 2003009421**
**23.04.2003 JP 2003118396**

(71) Applicant: **MITSUBISHI GAS CHEMICAL COMPANY, INC.**
**Chiyoda-ku, Tokyo (JP)**

(72) Inventors:
- **Oguro, Dai**
  **Hiratsuka-shi Kanagawa (JP)**
- **Hayashi, Takeo**
  **Hiratsuka-shi Kanagawa (JP)**
- **Echigo, Masatoshi**
  **Hiratsuka-shi Kanagawa (JP)**

(74) Representative:
**Gille Hrabal Struck Neidlein Prop Roos**
**Patentanwälte**
**Brucknerstrasse 20**
**40593 Düsseldorf (DE)**

(54) **Resist composition**

(57) The resist composition of the invention comprises at least one resist compound and at least one acid or base generator capable of directly or indirectly generating an acid or a base by exposure to radiation. The resist compound satisfies all the following requirements: a) containing at least one acid-dissociating functional group in molecule thereof, b) containing at least one kind of functional group selected from the group consisting of urea group, urethane group, amido group and imido group in a molecule thereof, c) having a molecular weight of 500 to 5,000, d) having a branched structure, and e) satisfying the formula: $3 \leq F \leq 5$, wherein F is represented by (number of total atoms)/(number of total carbon atoms - number of total oxygen atoms). The resist composition has a high sensitivity, a high resolution, a high heat resistance and a good solubility to solvents.

FIG. 1

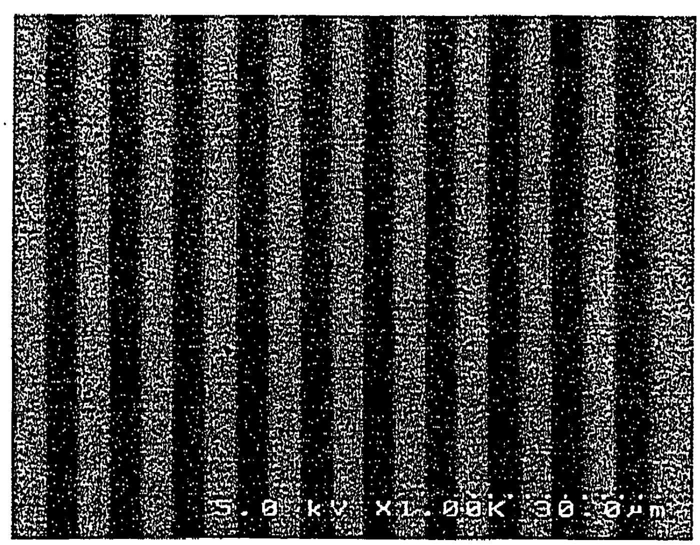


EP 1 443 362 A2

## Description

BACKGROUND OF THE INVENTION

1. Field of the Invention

The present invention relates to a radiation sensitive resist composition useful as an acid-amplified non-polymeric resist material, which comprises a compound having a specific chemical structure and an acid or base generator. The resist composition of the present invention is used as a radiation sensitive material that is sensitive to various radiations such as ultraviolet rays, far ultraviolet rays, electron beams and X-rays for forming masks, etc. in the production of electronics parts such as LSI and VLSI.

2. Description of the Prior Art

Conventionally known resist materials are generally polymeric materials capable of forming amorphous thin film. For example, a solution of poly(methyl methacrylate) in a solvent is applied on a substrate to form a thin resist film, which is then irradiated with ultraviolet rays, far ultraviolet rays, electron beams, X-rays, etc., to form line patterns having a width of about 0.1 μm.

The polymeric resist compounds generally have a molecular weight as large as about 10,000 to 100,000 and a broad molecular weight distribution. Therefore, in a lithographic fine process using the polymeric resist compounds, the surface of patterns is roughened to make it difficult to control the dimension of patterns and reduce the product yield. Thus, the conventional lithographic techniques using the known polymeric resist materials have limitations in fine processing. To produce finer patterns, there have been proposed various methods using resist materials having reduced molecular weights.

Known non-polymeric resist materials include, for example, (1) positive- or negative-type resists derived from fullerene, (2) positive- or negative-type resists derived from calixarene, (3) positive-type resists derived from starburst-type compounds, (4) positive-type resists derived from dendrimers, (5) positive-type resists derived from dendrimers/calixarene, (6) positive-type resists derived from highly branched starburst-type compounds, and (7) positive-type resists derived from ester linkage-containing starburst-type compounds mainly constituted by a trimesic add structure. The process for production of any of these resist materials is however complicated, and the costs of raw materials used therein are high.

The resist materials (1) are good in etching resistance but not practical in coating properties and sensitivity (Japanese Patent Application Laid-Open Nos. 7-134413, 9-211862, 10-282649, 11-143074 and 11-258796). The resist materials (2) are excellent in etching resistance, but fail to form satisfactory patterns because of a poor solubility to a developing solution (Japanese Patent Application Laid-Open Nos. 11-72916, 11-322656 and 9-236919). The resist materials (3) have a low heat resistance and thereore tend to cause the distortion of patterned images during the heat treatment after exposure to light (Japanese Patent Application Laid-Open Nos. 2000-305270, 2002-99088 and 2002-99089). The resist materials (4) are less practicable because a complicated production process is required and the distortion of patterned images due to their low heat resistance occurs during the heat treatment after exposure to light ("Proceedings of SPIE", vol. 3999(2000). pp. 1202-1206). The resist materials (5) are less practicable because a complicated production process is required and the raw materials are expensive (Japanese Patent Application Laid-Open Nos. 2002-49152 and 2003-183227). The resist materials (6) are less practicable because a complicated production process is required and the raw materials are expensive. The resist materials (7) are less practicable because the distortion of patterned images due to their low heat resistance is likely to occur during the heat treatment after exposure to light and the adhesion to substrates is poor (Japanese Patent Application Laid-Open No. 2002-328466). In addition, Japanese Patent Application Laid-Open No. 2002-363123 discloses a photosensitive compound having a hydrophobic group selected from hydrocarbon groups and heterocyclic groups, a linking group, and a hydrophilic group protected by a protecting group that can be eliminated upon exposure to light. However, a composition containing a resist compound that has a chemical structure satisfying the specific requirement as mentioned below is not disclosed therein.

SUMMARY OF THE INVENTION

An object of the present invention is to provide a radiation sensitive composition that is sensitive not only to ultraviolet rays such as i-rays and g-rays but also to radiation such as visible lights, excimer lasers from KrF, etc., electron beams, X-rays and ion beams. Another object of the present invention is to provide a simple method of producing a non-polymeric radiation sensitive resist composition that exhibits a high sensitivity, a high resolution, a high heat resistance and a good solubility to solvent.

As the result of extensive study, the inventors have found that the above objects are effectively achieved by a composition comprising a compound having a chemical structure satisfying specific requirements and an acid or base generator capable of directly or indirectly generating an acid or a base by exposure to radiation.

Thus, the present invention provides a resist composition comprising at least one resist compound satisfying all the following requirements a) to f):

a) containing at least one acid-dissociating functional group in molecule thereof,
b) containing at least one kind of functional group selected from the group consisting of urea group, urethane group, amido group and imido group in a molecule thereof,
c) having a molecular weight of 500 to 5,000,
d) having a branched structure,
e) satisfying the formula: $3 \leq F \leq 5$, wherein F is represented by (number of total atoms)/(number of total carbon atoms - number of total oxygen atoms), and
f) having a nitrogen content of 1 to 20% by mass; and

at least one acid or base generator capable of directly or indirectly generating an acid or a base by exposure to radiation selected from the group consisting of visible lights, ultraviolet rays, excimer lasers, electron beams, X-rays and ion beams.

Further, the present invention provides a process for forming resist patterns, comprising the steps of:

forming a resist film on a substrate by applying the above resist composition to the substrate;
heat-treating the resist film;
exposing the heat-treated resist film by irradiating it with radiation selected from the group consisting of visible lights, ultraviolet rays, excimer lasers, electron beams, X-rays and ion beams, optionally followed by a heat-treatment of the exposed resist film; and
developing the exposed resist film with a developing solution.

The acid-amplified non-polymeric radiation sensitive resist composition of the present invention is highly sensitive, and therefore, can produce resist patterns having a high resolution. This enables the production of semiconductor devices of high integration in a high productivity.

BRIEF DESCRIPTION OF THE DRAWINGS

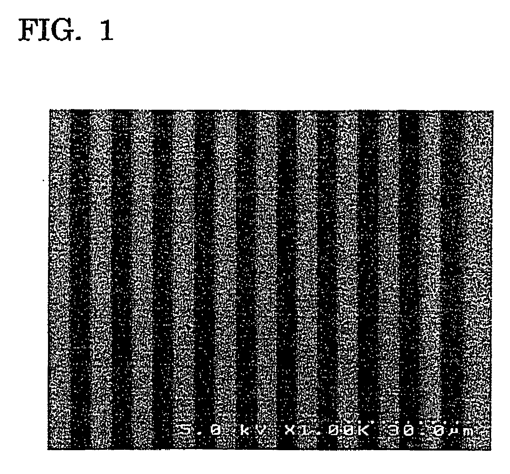

Fig. 1 is a scanning electron microphotograph showing line patterns of the resist patterns obtained in Example 9.

DETAILED DESCRIPTION OF THE INVENTION

The present invention will be described in detail below.

The resist composition of the present invention comprises at least one resist compound and at least one acid or base generator. The resist compound simultaneously satisfies all the following requirements a) to f).

a) The resist compound has at least one, preferably 1 to 12, more preferably 3 to 12 acid-dissociating functional groups in a molecule thereof.

The "acid-dissociating functional group referred to herein is a substituent group that is cleaved in the presence of an acid to generate an acidic group such as phenolic hydroxyl group and carboxyl group. Examples thereof include alkoxy group, alkylsulfanil group, acyloxy group, alkoxycarbonyl group, alkoxycarbonyloxy group and phenoxycarbonyloxy group. To make the formation of resist patterns having still higher sensitivity and resolution possible, it is preferred for the acid-dissociating groups to succeedingly cause the cleavage reaction in the presence of acid. With the presence of the acid-dissociating functional group, the acid generated by exposure to radiation, even if in a small amount, extensively induces the reaction by its catalytic function to exhibit a large effect on the increase in the sensitivity and the developing contrast.

b) The resist compound has at least one kind of functional group selected from the group consisting of urea group, urethane group, amido group and imido group in a molecule thereof.

The resist compound has at least one kind of functional group selected from the group consisting of urea group, amido group, urethane group and imido group, preferably selected from the group consisting of urea group, amido group and urethane group, in a total number of three or more. Also, the resist compound may have another nitrogen-containing functional group. Examples of the nitrogen-containing functional groups include, but are not limited to, tertiary amine group, quaternary ammonium group, imino group, azide group, and functional groups containing a

heterocyclic amine such as pyridine, pyrrole, imidazole, indole, quinoline, pyrimidine, triazine, pyrrolidine and morpholine. It is preferred for the resist composition to have no basic functional group. The above functional groups provide a sufficient heat resistance and adhesion to substrate which are required in the pattern formation, and make the process for producing the resist compound having a molecular weight of about 500 to 5,000 simplified.

c) The resist compound has a molecular weight of 500 to 6,000.

The molecular weight of the resist compound is 500 to 5,000, preferably 600 to 3,000 and more preferably 700 to 2,000. With the molecular weight in the above range, a good film-forming property can be attained and the developability and the alkali developability can be improved.

d) The resist compound has a branched structure.

The "branched structure" referred to herein means a chemical structure satisfying at least one of the following requirements (1) to (4):

(1) having a tertiary carbon atom or a tertiary nitrogen atom which is not included in a cyclic structure;
(2) having a quaternary carbon atom;
(3) having at least one aromatic ring or aliphatic ring having three or more substituent groups; and
(4) having a tertiary phosphorus atom.

The branched structure keeps resist films amorphous stably for a long period of time and makes a resist material excellent in film-forming property, light transmitting property, solubility to solvent, etching resistance, etc. which are required for formation of resist patterns. In addition, since the branched structure allows to increase the number of photosensitive groups, the sensitivity of the resist composition can be increased.

e) The resist compound satisfied the formula: $3 \leq F \leq 5$, wherein F is represented by (number of total atoms) /(number of total carbon atoms - number of total oxygen atoms).

When F exceeds 5, the properties such as sensitivity, resolution and etching resistance may be deteriorated.

f) The resist compound has a nitrogen content of 1 to 20% by mass.

The resist compound is preferably represented by the following formula (1):

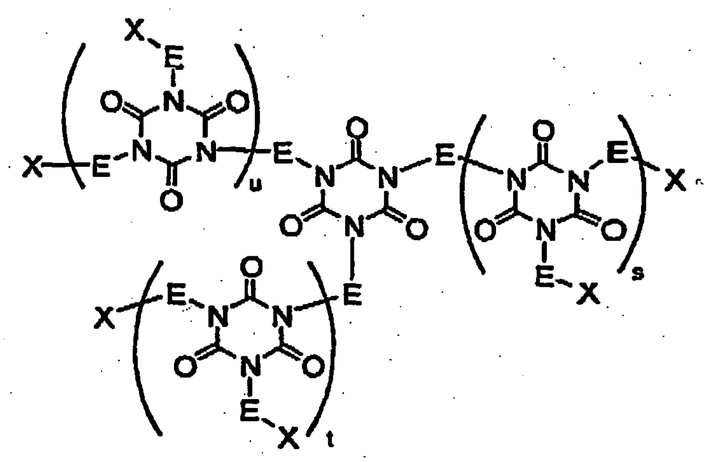

(1)

In the formula (1), groups X are each independently hydrogen or a group represented by the following formulae (I) to (III), and at least three of the groups X are represented by the formulae (I) to (III), preferably by the formulae (I) and (II).

Groups E are each independently $C_1$ to $C_{12}$ divalent acyclic hydrocarbon group such as methylene, ethylene, propylene, butylene and sec-butylene; divalent cyclic hydrocarbon group such as phenylene, tolylene, xylylene, cyclohexylene, cyclohexylenedimethylene and isophoronylene; or substituted alkylene group such as methoxyethylene, ethoxymethylene, ethoxethylene, methoxypropylene and ethoxypropylene, with methylene, tolylene, cyclohexylenedimethylene and isophoronylene being preferred.

The subscripts s, t and u are independently integer of 0 to 3, and s + t + u is preferably 0 to 5, more preferably 0 to 2 and most preferably zero.

In the following formulae (I) to (III):

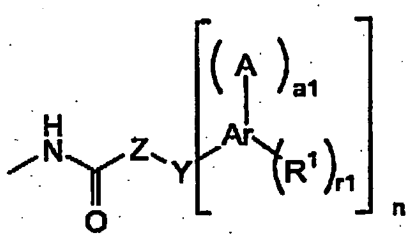
(I)

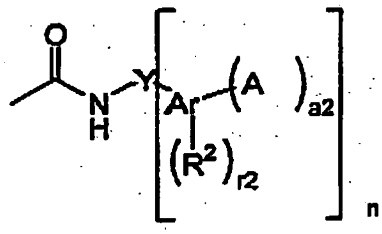
(II)

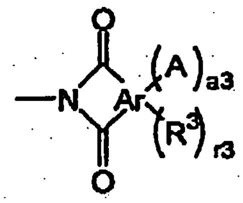
(III)

,

$R^1$ to $R^3$ are each independently hydrogen; $C_1$ to $C_{12}$ linear hydrocarbon group such as methyl, ethyl, propyl, butyl, pentyl, hexyl, heptyl, octyl, nonyl, decyl and dodecyl; $C_3$ to $C_{12}$ cyclic hydrocarbon group such as phenyl, tolyl, biphenyl, naphthyl, cyclohexyl, substituted cyclohexyl, cyclododecyl, adamantyl and substituted adamantyl; alkoxy group such as methoxy, ethoxy, propoxy, butoxy and phenoxy; or 1-branched alkyl group such as isopropyl, sec-butyl, tert-butyl, 1,1-dimethylpropyl. 1-methylbutyl and 1,1-dimethylbutyl, with hydrogen being preferred.

Groups Ar are each independently $C_6$ to $C_{12}$ aromatic hydrocarbon group such as phenyl, naphthyl and biphenyl, with phenyl being preferred.

Y is independently $C_1$ to $C_{12}$ divalent acyclic hydrocarbon group such as methylene, ethylene, propylene, butylene and sec-butylene; divalent cyclic hydrocarbon group such as phenylene, tolylene, xylylene, cyclohexylene, cyclohexylenedimethylene and isophoronylene; substituted alkylene group such as methoxyethylene, ethoxymethylene, ethoxyethylene, methoxypropylene and ethoxypropylene; or single bond, with methylene, tolylene, cyclohexylenedimethylene, isophoronylene and single bond being preferred. The "single bond" referred to herein means a linkage for directly bonding different constituting units.

Z is independently single bond or substituent group selected from the group consisting of -O-, -S- and -NH-. with -O-, -NH- and single bond being particularly preferred. When Z is -O-, -S-, -NH- or single bond, the design of chemical structure is easy.

Subscripts a1 to a3 are each independently integer of 1 to 9, and subscripts r1 to r3 are each independently integer of 0 to 8, satisfying the formulae, $a1 + r1 \leq 9$, $a2 + r2 \leq 9$ and $a3 + r3 \leq 8$. Preferably, each of a1 to a3 is 1, and each of r1 to r3 is zero.

Subscript n is an integer of 1 to 5, preferably 1 or 2 and more preferably 1.

Groups A are each independently hydrogen or acid-dissociating functional group represented by the following formulae (IV) to (VIII) with the proviso that at least one of the groups A is represented by the formulae (IV) to (VIII), preferably represented by the formula (IV).

In the following formulae (IV) to (VIII):

$$—OR^4 \qquad (IV)$$

$$—SR^5 \qquad (V)$$

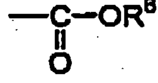
(VI)

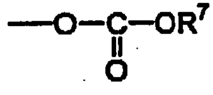
(VII)

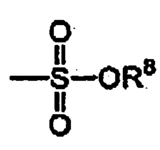
(VIII)

,

$R^6$ and $R^8$ are each independently hydrogen; $C_1$ to $C_{12}$ linear hydrocarbon group such as methyl, ethyl, propyl, butyl, pentyl, hexyl, heptyl, octyl, nonyl, decyl and dodecyl; a $C_3$ to $C_{12}$ cyclic hydrocarbon group such as phenyl, tolyl, biphenyl, naphthyl, cyclohexyl substituted cyclohexyl, cyclododecyl, adamantyl and substituted adamantyl; alkoxy such as methoxy, ethoxy, propoxy, butoxy and phenoxy; or 1-branched alkyl such as isopropyl, sec-butyl, tert-butyl, 1,1-dimethylpropyl, 1-methylbutyl and 1,1-dimethylbutyl, with cyclohexyl and tert-butyl being preferred.

$R^4$, $R^5$ and $R^7$ are independently hydrogen, substituted methyl groups, monosubstituted ethyl groups, monosubstituted n-propyl groups, 1-branched alkyl groups, silyl groups, germyl groups, acyl groups, alkoxycarbonyl groups, monosubstituted alkoxymethyl groups or cyclic substituent groups, and at least one of $R^4$ to $R^8$ is a characteristic group other than hydrogen.

Examples of the substituted methyl groups include methoxymethyl, methylthiomethyl, ethoxymethyl, ethylthiomethyl, methoxyethoxymethyl, benzyloxymethyl, benzylthiomethyl, phenacyl, bromophenacyl, methoxyphenacyl, methylthiophenacyl, α-methylphenacyl, cyclopropylmethyl, benzyl, diphenylmethyl, triphenylmethy-1, bromobenzyl, nitrobenzyl, methoxybenzyl, methylthiobenzyl, ethoxybenzyl, ethylthiobenzyl, piperonyl, methoxycarbonylmethyl ethoxycarbonylmethyl, n-propoxycarbonylmethyl, isopropoxycarbonylmethyl, n-butoxycarbonylmethyl, and tert-butoxycarbonylmethyl.

Examples of the 1-substituted ethyl groups include 1-methoxyethyl, 1-methylthioethyl, 1,1-dimethoxyethyl, 1-ethoxyethyl, 1-ethylthioethyl, 1,1-diethoxyethyl, 1-cyclohexyloxyethyl, 1-phenoxyethyl, 1-phenylthioethyl, 1,1-diphenoxyethyl, 1-benzyloxyethyl, 1-benzylthioethyl, 1-cyclopropylethyl, 1-phenylethyl, 1,1-diphenylethyl, 1-methoxycarbonylethyl, 1-ethoxycarbonylethyl, 1-n-propoxycarbonylethyl, 1-isopropoxycarbonylethyl, 1-n-butoxycarbonylethyl, and 1-tert-butoxycarbonylethyl.

Examples of the 1-substituted propyl groups include 1-methoxypropyl and 1-ethoxypropyl.

Examples of the 1-branched alkyl groups include isopropy, sec-butyl, tert-butyl 1,1-dimethylpropyl, 1-methylbutyl, and 1,1-dimethylbutyl.

Examples of the silyl groups include trimethylsilyl, ethyldimethylsilyl, methyldiethylsilyl, triethylsilyl, isopropyldimethylsilyl, methyldiisopropylsilyl, triisopropylsilyl, tert-butyldimethylsilyl, methyl-di-tert-butylsilyl, tri-tert-butylsilyl, phenyldimethylsilyl, methyldiphenylsilyl, and triphenylsilyl.

Examples of the germyl groups include trimethylgermyl, ethyldimethylgermyl methyldiethylgermyl, triethylgermyl, isopropyldimethylgermyl, methyldiisopropylgermyl, triisopropylgermyl, tert-butyldimethylgermyl, methyldi-tert-butylgermyl, tri-tert-butylgermyl, phenyldimethylgermyl, methyldiphenylgermyl, and triphenylgermyl.

Examples of the acyl groups include acetyl, propionyl, butyryl, heptanoyl, hexanoyl, valeryl, pivaloyl, isovaleryl, lauroyl, myristoyl, palmitoyl, stearoyl, oxalyl, malonyl, succinyl, glutaryl, adipoyl, piperoyl, suberoyl, azelaoyl, sebacoyl, acryloyl, propioloyl, methacryloyl, crotonoyl, oleoyl, maleoyl, fumaroyl, mesaconoyl, campholoyl, benzoyl, phthaloyl, isophthaloyl, terephthaloyl, naphthoyl, toluoyl, hydroatropoyl, atropoyl, cinnamoyl, furoyl, thenoyl, nicotinoyl, isonicotinoyl, p-toluenesulfonyl, and mesyl.

Examples of the alkoxycarbonyl groups include methoxycarbonyl, ethoxycarbonyl, isopropoxycarbonyl, and tert-butoxycarbonyl.

Examples of the 1-substituted alkoxymethyl groups include 1-cyclopentylmethoxymethyl 1-cyclopentylethoxymethyl, 1-cyclohexylmethoxymethyl, 1-cyclohexylethoxymethyl, 1-cyclooctylmethoxymethyl, and 1-adamantylmethoxymethyl.

Examples of the cyclic substituent groups include cyclopropyl, cyclobutyl, -cyclopentyl, cyclohexyl, cyclohexenyl, p-methoxycyclohexyl, tetrahydropyranyl, tetrahydrofuranyl, tetrahydrothiopyranyl, tetrahydrothiofuranyl, 3-bromotetrahydropyranyl, 4-methoxytetrahydropyranyl, 4-methoxytetrahydrothiopyranyl, 3-tetrahydrothiophene-1,1-dioxide, adamantyl, and alkyladamantyl.

Of these acid-dissociating functional groups, preferred as $R^4$, $R^5$ and $R^7$ are tert-butoxycarbonyl, tert-butoxycarbonylmethyl, 1-methoxyethyl, 1-ethoxyethyl, 1-cyclohexyloxyethyl, tert -butyl, trimethylsilyl, tetrahydropyranyl and 1-cyclohexylmethoxymethyl.

As described above, in the formula (1), s + t + u is preferably 0 to 5, more preferably 0 to 2 and most preferably zero. Namely, the resist compound used in the present invention is preferably represented by the following formulae (2), (3) and (4):

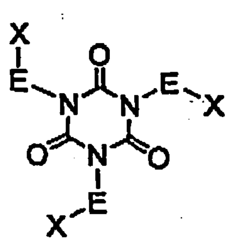

(2)

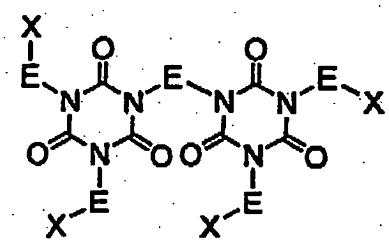

(3)

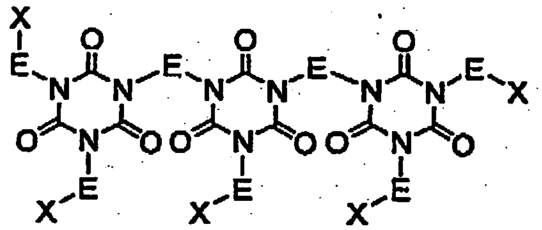

(4)

wherein X and E are the same as defined above, and more preferably represented by the formula (2). With the compounds represented by the formulae (2) to (4), a high resolution is attained and a line etch roughness can be reduced.

X in the formula (1) is preferably selected from substituent groups represented by the formulae (IX) to (XI):

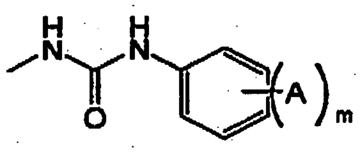

(IX)

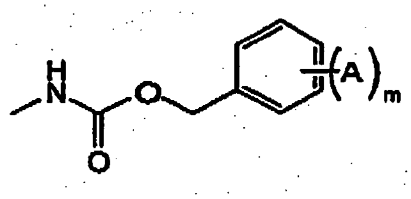

(X)

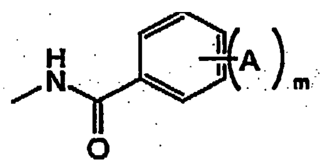

(XI)

wherein A is the same as defined above and m is an integer of 1 to 2.

Further, at least one of A in the formulae (I) to (III) is preferably a substituent group represented by the following formulae (XII) to (XV):

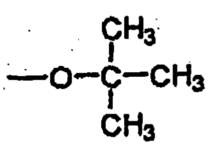

(XII)

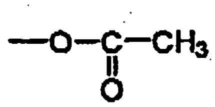

(XIII)

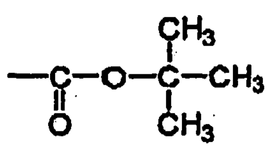

(XIV)

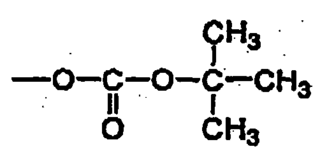

(XV)

The nitrogen content of the resist compound is preferably 1 to 20% by mass, more preferably 2 to 15% by mass and more preferably 5 to 15% by mass. When the nitrogen content falls within the above range, the resist composition is excellent in the sensitivity and resolution, and has a good heat resistance and adhesion to substrate which are required for forming resist patterns.

The resist compound is preferably produced from at least one polyisocyanate having three or more isocyanate groups. Such a polyisocyanate enables the production of the resist compound having a branched structure by easy process.

Preferred examples of the polyisocyanate having three or more isocyanate groups include, but not particularly limited to, isocyanurates, biuret derivatives, allophanate derivatives and urethane derivatives each being derived from diisocyanates such as tolylene diisocyanate, bis(isocyanatophenyl)methane, bis(isocyanatocyclohexyl)methane, phenylene diisocyanate, cyclohexane diisocyanate, isophorone diisocyanate, hexamethylene diisocyanate, bis(isocyanatomethyl)cyclohexane, m-xylene diisocyanate, norbornane diisocyanate, tolidine diisocyanate, naphthalene diisocyanate, lysine diisocyanate, tetramethylxylene diisocyanate and trimethylhexamethylene diisocyanate; oligomers of isocyanatophenylmethane; and triisocyanates such as tris(isocyanatophenyl)methane, tris(isocyanatophenyl)thiophosphate, mesitylene triisocyanate, triisocyanatobenzene, lysine ester triisocyanate, 1,6,11-undecane triisocyanate, 1,8-diisocyanato-4-isocyanatomethyloctane, 1,3,6-hexamethylene triisocyanate and bicycloheptane triisocyanate. Since the above polyisocyanate compounds have been extensively used as a curing agent for urethane-based paints and are relatively inexpensive, the raw material cost can be reduced. Of these polyisocyanates, isocyanurates derived from tolylene diisocyanate, bis(isocyanatophenyl)methane, isophorone diisocyanate, bis(isocynanatomethyl)cyclohexane and m-xylene diisocyanate; tris(isocyanatophenyl)methane and tris(isocyanatophenyl)thiophosphate are especially preferred because these compounds have a high heat resistance capable of withstanding high temperatures in semiconductor production process.

The method for producing the resist compound used in the present invention is not particularly restricted. In particular, the resist compound is preferably produced by reacting the polyisocyanate having three or more isocyanate groups with an aminophenol compound or a hydroxyalkylphenol compound, and then reacting the resultant reaction product with a reagent for introducing the acid-dissociating functional group in the presence of a base catalyst, because all the production steps can be conducted in a single reaction vessel to make the production easier and more practical.

The reagent for introducing the acid-dissociating functional group may include active carboxylic acid derivatives such as acid chlorides, acid anhydrides and dicarbonates each having an acid-dissociating functional group, and alkyl halides, with add anhydrides and dicarbonates being particularly preferred. The acid-dissociating functional groups are the groups as recited with respect to $R^4$, $R^5$ and $R^7$, namely, substituted methyl groups, 1-substituted ethyl groups, 1-substituted n-propyl groups, 1-branched alkyl groups, silyl groups, germyl groups, acyl groups, alkoxycarbonyl groups, 1-substituted alkoxymethyl groups and cyclic groups. Any alkaline compound may be used as the base catalyst. For example, at least one compound selected from the group consisting of alkaline compounds such as mono-, di- or trialkylamines, mono-, di- or trialkanolamines, heterocyclic amines, tetramethylammonium hydroxide (TMAH) and coline, and metal compounds such as alkylammonium salts and alcoholates may be preferably used, with triethylamine being particularly preferred.

The aminophenol compound and the hydroxyalkyl compound are not particularly limited as long as having a functional group which is reactive to isocyanates more than phenolic OH.

Examples of the aminophenol compound include p-aminophenol, m-aminophenol, o-aminophenol, 4-aminocatechol, 3-aminocatechol, 2-aminoresorcinol, 4-aminoresorcinol, 5-aminoresorcinol, 2-aminohydroquinone, 4-aminopyrogallol, 5-aminopyrogallol, 2-aminomethylphenol, 3-aminomethylphenol, 4-aminomethylphenol, 4-aminomethylcatechol, 3-aminomethylcatechol, 2-aminomethylresorcinol, 4-aminomethylresorcinol, 5-aminomethylresorcinol, 2-aminomethylhydroquinone, 4-aminomethylpyrogallol, 5-aminomethylpyrogallol, 2-aminofluoroglycinol, and 2-aminomethylfluoroglycinol, with p-aminophenol and m-aminophenol being particularly preferred.

Examples of the hydroxyalkylphenol compound include 4-hydroxymethylphenol, 3-hydroxymethylphenol, 2-hydroxymethylphenol, 4-hydroxymethylcatechol, 3-hydroxymethylcatechol, 2-hydroxymethylresorcinol, 4-hydroxymethylresorcinol, 5-hydroxymethylresorcinol, 2-hydroxymethylhydroquinone, 4-hydroxymethylpyrogallol, and 5-hydroxymethylpyrogallol, with 4-hydroxymethylphenol and 5-hydroxymethylresorcinol being particularly preferred.

The resist compound is produced, for example, by the following method. The polyisocyanate having three or more isocyanate groups is reacted with an equivalent amount of a compound, such as the aminophenol compound, having a phenolic hydroxyl group and an amino group which is more reactive than the phenolic hydroxyl group, in an aprotic polar solvent such as dimethylacetamide (DMAc) at ordinary temperature under ordinary pressure to allow the amino group to selectively react with the isocyanate group. Although the reaction may proceeds in the absence of a catalyst, a reaction rate can be increased in the presence of at least one base catalyst mentioned above.

Then, the resultant product is reacted with di-tert-butyl dicarbonate in the same reaction vessel in the presence of the base catalyst such as triethylamine at 60 to 70°C under ordinary pressure for 6 to 7 h to introduce the acid-dissociating functional group such as tert-butoxycarbonyl. The reaction product is re-precipitated from distilled water, washed with distilled water and then dried to obtain the resist compound.

In addition, the resist compound may also be produced by condensing a compound having three or more amino groups with a compound obtained by reacting hydroxybenzoic acid, dihydroxybenzoic acid or tirhydroxybenzoic acid with the reagent for introducing the acid-dissociating functional group in the presence of the base catalyst. This

method is preferred because the production of by-products can be avoided.

Examples of the compound having three or more amino groups include, but not particularly limited to, mesitylenetriamine, triaminobenzene, pararosaniline, tris(aminophenyl)methane, tris(aminophenyl)thiophosphate, lysine ester triamine, 1,6,11-undecanetriamine, 1,8-diamino-4-aminomethyloctane, 1,3,6-hexamethylenetriamine, bicycloheptanetriamine, and norbornanetriamine, with mesitylenetriamine, triaminobenzene and pararosaniline being particularly preferred.

Further, the resist compound may also be produced by condensing a compound having three or more carboxyl groups with a compound obtained by reacting the aminophenol compound or the hydroxyalkylphenol compound with the reagent for introducing the acid-dissociating functional group in the presence of the base catalyst. This method is preferred because the production of by-products can be avoided.

Examples of the compound having three or more carboxyl groups include benzenetetracarboxylic acids, cyclohexanetetracarboxylic acids, benzenetricarboxylic acids, and cyclohexanetricarboxylic acids, with benzenetricarboxylic acids such as trimesic acid and cyclohexanetricarboxylic acids such as hydrogenated trimesic acids being particularly preferred.

The resist composition of the present invention contains at least one of the above resist compounds. Using one resist compound, a high sensitivity and resolution may be attained, and the combined use of two or more may improve the film-forming property and adhesion to substrate.

The resist composition of the present invention may contain a resist compound in which all of $R^1$ to $R^8$ in the formulae (I) to (VIII) are hydrogen. The use of such a resist compound may result in a high sensitivity and resolution and may reduce the etch roughness.

The resist composition of the present invention contains comprises at least one resist compounds and at least one acid or base generator (acid generator or base generator) capable of directly or indirectly generating an acid or a base by exposure to radiation such as visible lights, ultraviolet rays, excimer lasers, electron beams. X-rays and ion beams. When at least one of the groups A in the formulae (I) to (III) and to (XI) is represented by the formula (VII), the base generator may be used in place of the add generator. In the presence of the base, the acid-dissociating group is eliminated and leaves a phenolic hydroxyl group. The resist composition of the present invention may further contain at least one solvent capable of dissolving the resist compound and the acid or base generator.

The resist compound is of an acid-amplified type and the acid-dissociating functional group is eliminated and leaves a phenolic hydroxyl group in the presence of an acid. The phenolic hydroxyl group acts as a self-catalyst to effectively promote the elimination of the acid-dissociating functional groups to make the resist compound alkali-soluble. Therefore, the resist compound can be used as an alkali-developing positive-type resist. The method of generating the acid is not particularly restricted. For example, the acid may be generated at the area exposed to radiation such as ultraviolet rays and high-energy rays when the resist composition contains the acid generator.

More specifically, in the present invention, any method may be used as long as the acid is suitably generated within the system. The use of excimer lasers in place of ultraviolet rays such as g-rays and i-rays enables a finer processing. In addition, if high-energy rays such as electron beams, X-rays and ion beams are used, the resist composition can be still more finely processed.

The acid generator is preferably at least one compound selected from the group consisting of the compounds represented by the following formulae (5) to (12).

In the formula (5):

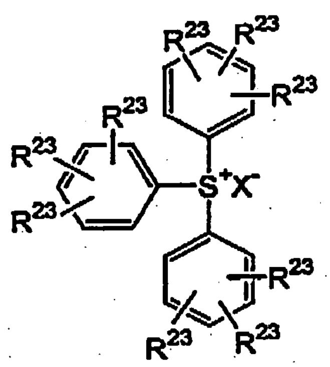

(5)

groups $R^{23}$ may be the same or different and are each independently hydrogen, linear, branched or cyclic alkyl, linear, branched or cyclic alkoxy, hydroxyl or halogen; and $X^-$ is sulfonic acid ion having alkyl, aryl, halogen-substituted alkyl or halogen-substituted aryl, or halide ion.

The compound represented by the formula (5) is preferably at least one compound selected from the group consisting of triphenylsulfonium trifluoromethanesulfonate, triphenylsulfonium nonafluoro-n-butanesulfonate, triphenylsulfonium perfluoro-n-octanesulfonate, diphenyl-4-methylphenylsulfonium trifluoromethanesulfonate, di-2,4,6-trimethylphenylsulfonium trifluoromethanesulfonate, diphenyl-4-tert-butoxyphenylsulfonium trifluoromethanesulfonate, diphenyl-4-tert-butoxyphenylsulfonium nonafluoro-n-butanesulfonate, diphenyl-4-hydroxyphenylsulfonium trifluoromethanesulfonate, bis(4-fluorophenyl)-4-hydroxyphenylsulfonium trifluoromethanesulfonate, diphenyl-4-hydroxyphenylsulfonium nonafluoro-n-butanesulfonate, bis(4-hydroxyphenyl)phenylsulfonium trifluoromethanesulfonate, tri (4-methoxyphenyl)sulfonium trifluoromethanesulfonate, tri(4-fluorophenyl)sulfonium trifluoromethanesulfonate, triphenylsulfonium p-toluenesulfonate, triphenylsulfonium benzonesulfonate, diphenyl-2,4,6-trimethylphenyl-p-toluenesulfonate; diphenyl-2,4,6-trimethylphenylsulfonium-2-trifluoromethylbenzonesulfonate, diphenyl-2,4,6-trimethylphenylsulfonium-4-trifluoromethylbenzenesulfonate, diphenyl-2,4,6-trimethylphenylsulfonium-2,4-difluorobenzenesulfonate, diphenyl-2,4,6,trimethylphenylsulfonium hexafluorobenzenesulfonate, diphenylnaphthylsulfonium trifluoromethanesulfonate, diphneyl-4-hydroxyphenylsulfonium p-toluenesulfonate, triphenylsulfonium 10-camphorsulfonate and diphenyl-4-hydroxyphenylsulfonium 10-camphorsulfonate.

In the formula (6):

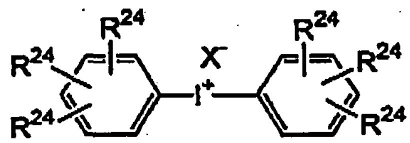

(6)

groups $R^{24}$ may be the same or different and are each independently hydrogen, linear, branched or cyclic alkyl, linear, branched or cyclic alkoxy, hydroxyl or halogen.

The compound represented by the formula (6) is preferably at least one compound selected from the group consisting of bis(4-tert-butylphenyl)iodonium trifluoromethanesulfonate, bis(4-tert-butylphenyl)iodonium nonafluoro-n-butanesulfonate, bis(4-tert-butylphenyl)iodonium perfluoro-n-octanesulfonate, bis(4-tert-butylphenyl)iodonium p-toluenesulfonate, bis(4-tert-butylphenyl)iodonium benzenesulfonate, bis(4-tert-butylphenyl)iodoniurn 2-trifluoromethylbenzenesulfonate, bis(4-tert-butylphenyl)iodonium 4-trifluoromethylbenzenesulfonate, bis(4-tert-butylphenyl)iodonium 2,4-difluorobenzenesulfonate, bis(4-tert-butylphenyl)iodonium hexafluorobenzenesulfonate, bis(4-tert-butylphenyl)iodonium 10-camphorsulfonate, diphenyliodonium trifluoromethanesulfonate, diphenyliodonium nonafluoro-n-butanesulfonate, diphenyliodonium perfluoro-n-octanesulfonate, diphenyliodonium p-toluenesulfonate, diphenyliodonium benzenesulfonate, diphenyliodonium 10-camphorsulfonate, diphenyliodonium 2-trifluoromethylbenzenesulfonate, diphenyliodonium 4-trifluoromethylbenzenesulfonate, diphenyliodonium 2,4-difluorobenzenesulfonate, diphenyliodonium hexafluorobenzenesulfonate, di(4-trifluoromethylphenyl)iodonium trifluoromethanesulfonate, di(4-trifluoromethylphenyl)iodonium nonafluoro-n-butanesulfonate, di(4-trifluoromethylphenyl)iodonium perfluoro-n-octanesulfonate, di(4-trifluoromethylphenyl)iodonium p-toluenesulfonate, di(4-trifluoromethylphenyl)iodonium benzenesulfonate and di(4-trifluoromethylphenyl)iodoniumm 10-camphorsulfonate.

In the formula (7):

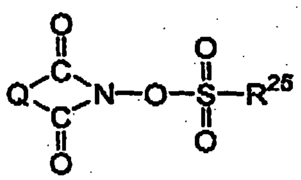

(7)

Q is alkylene, arylene or alkoxylene; $R^{25}$ is alkyl, aryl, halogen-substituted alkyl or halogen-substituted aryl.

The compound represented by the formula (7) is preferably at least one compound selected from the group consisting of N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hept-5-ene-2,3-dicarboximide, N-(trifluoromethylsulfonyloxy)naphthylimide, N-(10-camphorsulfonyloxy)succinimide, N-(10-camphorsul phenyloxy)phthalimide, N-(10-camphorsulfonyloxy)diphenylmaleimide, N-(10-camphorsulfonyloxy)bicyclo[2.2.1]hept-5-ene-2,3-dicarboximide, N-(10-camphorsulfonyloxy)naphthylimide, N-(n-octanesulfonyloxy)bicyclo[2.2.1]hept-5-ene-2,3-dicarboximide, N-(n-octanesulfonyloxy)naphthylimide, N-(p-toluenesulfonyloxy)bicyclo[2.2.1]hept-5-ene-2,3-dicarboximide, N-(p-toluenesulfonyloxy)naphthylimide, N-(2-trifluoromthylbenzenesulfonyloxy)bicyclo[2.2.1]hept-5-ene-2,3-dicarboximide, N-(2-trifluoromthylbenzenesulfonyloxy)naphthylimide, N-(4-trifluoromethylbenzenesulfonyloxy)bicyclo[2.2.1]hept-5-one-2,3-dicarboximide, N-(4-tritluoromethylbenzenesulfonyloxy)naphthylimide, N-(perfluorobenzenesulfonyloxy) bieyclo[2.2-1]hept-5-ene-2,3-dicarboximide, N(perfluorobenzenesulfonyloxy)naphthylimide, N-(1-naphthalenesulfonyloxy)bicyclo[2.2.1]hept-5-ene-2,3-dicarboximide, N-(1-naphthalenesulfonyloxy)naphthylimide, N-(nonafluoro-n-butanesulfonyloxy)bicyclo[2.2.1]hept-5-ene-2,3-dicarboximide, N-(nonafluoro-n-butanesulfonyloxy)naphthylimide, N-(perfluoro-n-octanesulfonyloxy)bicyclo[2.2.1]hept-5-ene-2,3-dicarboximide and N-(perfluoron-octanesulfonyloxy) naphthylimide.

In the formula (8):

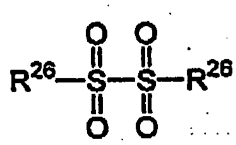

(8)

groups $R^{26}$ may be the same or different and are each independently linear, branched or cyclic alkyl which is optionally substituted, aryl which is optionally substituted, heteroaryl which is optionally substituted or aralkyl which is optionally substituted.

The compound represented by the formula (8) is preferably at least one compound selected from the group consisting of diphenyl disulfone, di(4-methylphenyl) disulfone, dinaphthyl disulfone, di(4-tert-butylphenyl) disulfone, di (4-hydroxyphenyl), disulfone, di(3-hydroxynaphthyl) disulfone, di(4-fluorophenyl) disulfone, di(2-fluorophenyl) disulfone and di(4-trifluoromethylphenyl) disulfone. In the formula (9):

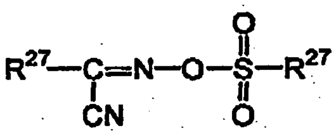

(9)

groups $R^{27}$ may be the same or different and are each independently linear, branched or cyclic alkyl which is optionally substituted, aryl which is optionally substituted, heteroaryl which is optionally substituted or aralkyl which is optionally substituted,

The compound represented by the formula (9) is preferably at least one compound selected from the group consisting of α-(methylsulfonyloximino)phenylacetonitrile, α-(methylsulfonyloxyimino)-4-methoxyphenylacetonitrile, α-(trifluoromethylsulfonyloxyimino)phenylacetonitrile, α-(trifluoromethylsulfonyloxyimino)-4-methoxyphenylacetonitrile, α-(ethylsulfonyloxyimino)-4-methoxyphenylacetonitrile, α-(propylsulfonyloxyimino)-4-methylphenylacetonitrile and α-(methylsulfonyloxyimino)-4-bromophenylacetonitrile.

In the formula (10),

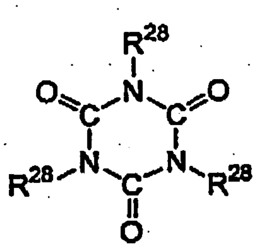

(10)

groups $R^{28}$ may be the same or different and are each independently halogenated alkyl group having one or more chlorine atoms and one or more bromine atoms. The halogenated alkyl group preferably has 1 to 5 carbon atoms.

In the formulae (11) and (12):

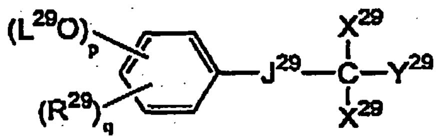

(11)

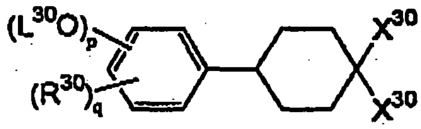

(12)

groups $R^{29}$ and $R^{30}$ are each independently $C_1$ to $C_3$ alkyl such as methyl, ethyl, n-propyl and isopropyl, cycloalkyl such as cyclopentyl and cyclohexyl, $C_1$ to $C_3$ alkoxy such as methoxy, ethoxy and propoxy, or aryl, preferably $C_6$ to $C_{10}$ aryl such as phenyl, toluyl and naphthyl; and groups $L^{29}$ and $L^{30}$ are each independently organic group having a 1,2-naphthoquinonediazido group. Preferred examples of the organic group having a 1,2-naphthoquinonediazido group include 1,2-naphthoquinonediazidosulfonyl groups such as 1,2-naphthoquinonediazido-4-sulfonyl group, 1,2-naphthoquinonediazido-5-sulfonyl group and 1,2-naphthoquinonediazido-6-sulfonyl group, with 1,2-naphthoquinonediazido-4-sulfonyl group and 1,2-naphthoquinonediazido-5-sulfonyl group being more preferred. Subscript p is an integer of 1 to 3 and subscript q is an integer of 0 to 4, satisfying the formula $1 \leq p+q < 5$; $J^{29}$ is a single bond, $C_1$ to $C_4$ polymethylene group, cycloalkylene group, phenylene group, group represented by the following formula (13):

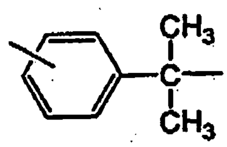

(13)

,

carbonyl group, ester group, amido group or ether group; $Y^{29}$ is hydrogen, alkyl or aryl; and $X^{29}$ and $X^{30}$ are each independently a group represented by the following formula (14).

In the formula (14):

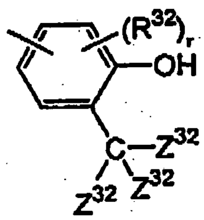

(14)

groups $Z^{32}$ are each independently alkyl, cycloalkyl or aryl; $R^{32}$ is alkyl, cycloalkyl or alkoxy; and r is an integer of 0 to 3.

Examples of the other acid generators include bissulfonyldiazomethanes such as bis(p-toluenesulfonyl)diazomethane, bis(2,4-dimethylphenylsulfonyl)diazomethane, bis(tert-butylsulfonyl)diazomethane, bis(n-butylsulfonyl)diazomethane, bis(isobutylsulfonyl)diazomethane, bis(isopropylsulfonyl)diazomethane, bis(n-propylsulfonyl)diazomethane and bis(cyclohexylsulfonyl)diazomethane; and halogen-containing triazine derivatives such as 2-(4-methoxyphenyl)-4,6-(bistrichloromethyl)-1,3,5-triazine, 2-(4-methoxynaphthyl)-4,6-(bistrichloromethyl)-1,3,5-triazine, tris(2,3-dibromopropyl)-1,3,5-triazine and tris(2,3-dibromopropyl)isocyanurate.

The base generator is preferably a compound capable of directly or indirectly generating a base by exposure to radiation such as ultraviolet rays and electron beams, and the compounds described in Japanese Patent Application Laid-Open No. 10-083079 may be used.

The acid or base generators may be used singly or in combination of two or more. The amount of the acid or base generator in the resist composition of the present invention is preferably 0.1 to 30 parts by weight, more preferably 0.5 to 20 parts by weight and still more preferably 1 to 15 parts by weight based on 100 parts by weight of the resist compound. If less than 0.1 part by weight, the sensitivity and resolution may be lowered. If exceeding 30 parts by

weight, the resist patterns may lose their proper sectional shape.

The resist composition of the present invention may further contain various additives such as acid-diffusion controllers, solubility controllers, solution accelerators, sensitizers and surfactants.

The resist composition of the present invention may contain an acid-diffusion controller that has an effect of controlling undesirable chemical reactions in unexposed area by inhibiting the acid generated from the acid generator upon the irradiation of radiation from being diffused to the unexposed area. Using such an add-diffusion controller, the storage stability and resolution of the resist composition can be improved. In addition, the change of line width of resist patterns due to varied time delay before and after irradiation of radiation can be prevented thereby to make the process stability extremely excellent. Examples thereof include nitrogen-containing basic compounds and basic compounds degradable by the irradiation of radiation such as basic sulfonium compounds and basic iodonium compounds. The acid-diffusion controllers may be used singly or in combination of two or more.

The blending amount of the acid-diffusion controller is preferably 0.001 to 10 parts by weight, more preferably 0.005. to 5 parts by weight and still more preferably 0.01 to 3 parts by weight based on 100 parts by weight of the resist compound. If less than 0.001 part by weight, the resolution and the precision of shape and dimension of patterns may be deteriorated depending on processing conditions. In addition, the proper shape of upper patterned layer may be lost, if the time delay from the irradiation of radiation until the post heat treatment is prolonged. If exceeding 10 parts by weight, the sensitivity and developability of unexposed are of resists may be deteriorated.

The solubility controller is a compound for adequately reducing the solution rate of the resist compound in the developing operation by lowering the solubility to a developing solution such as alkalis, if the solubility is too high. It is preferred for the solubility controller to cause no chemical change in the steps such as bake of resist film, irradiation of radiation and development.

Examples of the solubility controller include aromatic hydrocarbons such as naphthalene, phenanthrene, anthracene and acenaphthene; ketones such as acetophenone, benzophenone and phenyl naphthyl ketone; and sulfones such as methylphenyl sulfone, diphenyl sulfone and dinaphthyl sulfone. The solubility controllers may be used singly or in combination of two or more. The blending amount of the solubility controller varies depending upon the kind of the resist compound used, and is preferably 30 parts by weight or less and more preferably 10 parts by weight or less based on 100 parts by weight of the resist compound.

The solution accelerator is a compound for adequately increasing the solution rate of the resist compound in the developing operation by increasing the solubility to a developing solution such as alkalis, if the solubility is too low. It is preferred for the solution accelerator to cause no chemical change in the steps such as bake of resist film, irradiation of radiation and development. Examples of the solution accelerator include low-molecular weight phenolic compounds having about 2 to 6 benzene rings, such as bisphenols and tris(hydroxyphenyl)methane. The solution accelerators may be used singly or in combination of two or more. The blending amount of the solution accelerator varies depending upon the kind of the resist compound used, and is preferably 30 parts by weight or less and more preferably 10 parts by weight or less based on 100 parts by weight of the resist compound.

The sensitizer is a compound for increasing the generation amount of acid by absorbing the energy of irradiated radiation and transferring it to the acid generator, thereby enhancing the apparent sensitivity of the resist. Examples of the sensitizer include, but not particularly limited to, benzo phenones, biacetyls, pyrenes, phenothiazines, and, fluorenes. The sensitizers may be used singly or in combination of two or more. The blending amount of the sensitizer is preferably 30 parts by weight or less and more preferably 10 parts by weight or less based on 100 parts by weight of the resist compound.

The surfactant is a compound for improving the coating property and striation of the resist composition and the developability of the resist, etc. As the surfactant, there may be used any of anionic, cationic, nonionic and ampholytic surfactants, with nonionic surfactants being preferred because of their good affinity to solvents used for the radiation-sensitive composition. Examples of the nonionic surfactants include, but not particularly limited to, polyoxyethylene higher alkyl ethers, polyoxyethylene higher alkyl phenyl ethers, and higher fatty acid diesters of polyethylene glycol, being commercially available under the following tradenames: "EFTOP" of JEMCO Inc.; "MEGAFACE" of Dai-Nippon Ink & Chemicals, Incorporated; "FLUORAD" of Sumitomo 3M Ltd.; "ASAHIGUARD" and "SURFLON" of Asahi Glass Co., Ltd.; "PEPOL" of Toho Chemical Industry Co., Ltd.; "KP" of Shin-Etsu Chemical Co., Ltd.; and "POLYFLOW" of Kyoeisha Chemical Co., Ltd.

The blending amount of the surfactant is preferably 2 parts by weight or less in terms of effective ingredient based on 100 parts by weight of the resist compound. In addition, dyes or pigments may be blended in the resist composition to visualize latent images of exposed portions, thereby reducing adverse influence of halation during the exposing operation. Further, adhesive assistants may be blended in the resist composition to improve the adhesion to substrates.

Before use, the resist composition of the present invention is dissolved in a solvent so as to have a solid content of preferably 1 to 20% by mass, more preferably 1 to 16% by mass and still more preferably 1 to 10% by mass. The solution is then passed through a filter having, for example, a pore size of about 0.2 μm to prepare a resist solution.

Examples of the solvent for the resist composition include, but not particularly limited to, ethylene glycol monoalkyl ether acetates such as ethylene glycol monomethyl ether acetate and ethylene glycol monoethyl ether acetate; ethylene glycol monoalkyl ethers such as ethylene glycol monomethyl ether and ethylene glycol monoethyl ether; propylene glycol monoalkyl ether acetates such as propylene glycol monomethyl other acetate and propylene glycol monoethyl ether acetate (PGMEA); propylene glycol monoalkyl ethers such as propylene glycol monomethyl ether (PGME) and propylene glycol monoethyl ether; lactic acid esters such as methyl lactate and ethyl lactate (EL); aliphatic carboxylic acid esters such as methyl acetate, ethyl acetate, propyl acetate and butyl acetate; other esters such as methyl 3-methoxypropionate, ethyl 3-methoxypropionate, methyl 3-ethoxypropionate and ethyl 3-ethoxypropionate; aromatic hydrocarbons such as toluene and xylene; ketones such as 2-heptanone, 3-heptanone, 4-heptanone and cyclohexanone; and cyclic ethers such as tetrahydrofuran and dioxane. The solvents may be used singly or in combination of two or more.

The resist composition of the present invention may further contain at least one resin that is insoluble or hardly soluble in an aqueous alkali solution, but is rendered soluble therein by the action of an acid. Examples of such resins include resins obtained by modifying resins having a phenolic hydroxyl group such as phenol resins and polyhydroxystyrene by replacing the hydroxyl group with the acid-dissociating functional group, and poly(alkyl methacrylate).

The resist substrate referred to herein is a substrate having a resist film of the resist composition formed thereon. The patterned substrate referred to herein is a substrate having a patterned resist film which is formed by exposing and developing the resist film of the resist substrate. The "pattern-forming material" referred to herein means a composition capable of forming resist patterns by irradiation of radiation such as lights and electron beams, and has the same meaning as the "resist film." The "patterned wiring board" referred to herein is a board having wiring patterns obtained by etching the patterned substrate.

The resist pattern is formed as follows. First, the resist composition of the present invention is applied onto a substrate such as silicon wafer and aluminum-coated wafer by a coating method such as rotational coating, cast coating and roll coating to form a resist film. If necessary, the substrate may be coated in advance with a surface treating agent such as hexamethylene disilazane.

The resist film is then exposed by radiation such as ultraviolet rays and electron beams into desired patterns. The exposure conditions may be slected depending on the blending formulation, etc. of the radiation-sensitive composition. In the present invention, it is preferred to conduct a heat treatment after the irradiation of radiation to stably form highly accurate fine patterns by the exposure. The heating conditions vary depending upon the blending formulation, etc., and the heating temperature is preferably 20 to 260°C and more preferably 20 to 150°C.

Then, the exposed resist film is developed with an alkali developing solution to form desired resist patterns. As the alkali developing solution, there may be used an aqueous alkaline solution dissolving; for example, at least one alkaline compound selected from the group consisting of mono-, di- or trialkylamines, mono-, di or trialkanolamines, heterocyclic amines, tetramethylammonium hydroxide (TMAH) and choline in a concentration of preferably 1 to 10% by mass and more preferably 1 to 5% by mass.

Further, the alkali developing solution may contain an appropriate amount of an alcohol such as methanol, ethanol and isopropyl alcohol, or a surfactant mentioned above, with the addition of isopropyl alcohol in 10 to 30% by mass being particularly preferred. After developing with such an aqueous alkaline solution, developed patterns are usually washed with water.

After forming resist patterns, the patterned substrate is subjected to etching to obtain a patterned wiring board. The etching may be performed by known methods such as dry-etching using a plasma gas and wet-etching using an alkali solution, a copper (II) chloride solution, an iron (II) chloride solution, etc.

After forming resist patterns, the patterns may be plated, for example, by copper plating, solder plating, nickel plating or gold plating.

The remaining resist patterns may be stripped off by an organic solvent or an alkali aqueous solution stronger than the aqueous alkali solution used for the development. Examples of the organic solvent include PGMEA, PGME and EL. Examples of the aqueous strong alkali solution include 1 to 20% by mass aqueous sodium hydroxide solution and 1 to 20% by mass aqueous potassium hydroxide solution. The stripping of the resist patterns may be performed by dipping method, spray method, etc. The wiring board having the resist patterns thereon may be a multi-layer wiring board and may be formed with small through-holes.

The present invention will be described in more detail with reference to the following examples. However, it should be noted that the following examples are only illustrative and not intended to limit the invention thereto.

PRODUCTION OF RESIST COMPOUND

PRODUCTION EXAMPLE 1: Production of tBOC-TDIAP

Into 10 ml of a DMAc (reagent available from Kanto Chemical Co., Ltd.) solution of 3.27 g (30 mmol) of p-aminophenol (AP) (reagent available from Kanto Chemical Co., Ltd.), was slowly added dropwise a solution prepared by adding 10 ml of DMAc to 17.34 g of a 50 wt % butyl acetate solution of isocyanurate polyisocyanate derived from tolylenediisocyanate (TDI) ("BURNOCK D-800" available from Dai-Nippon Ink & Chemicals, Incorporated; NCO equivalent: 592; non-volatile content: 51% by weight), and the resultant mixture was stirred at room temperature for one hour. After slowly added dropwise with 8.0 g (36 mmol) of di-tert-butoxydicarbonate (reagent available from ACROS ORGANICS Co., Ltd.) and 4.0 g of triethylamine (reagent available from Kanto Chemical Co., Ltd.), the mixture was stirred at 60°C for 7 h. The resultant reaction solution was added to a large amount of water and the re-precipitation was repeated to obtain a white powder (tBOC-TDIAF composition). The white powder was purified by column chromatography using a mixed solvent of hexane/ethyl acetate = 3/4 to collect the main fraction, which was finally dried under reduced pressure to obtain 21.1 g of the aimed product (tBOC-TDIAP compound). The structure thereof was confirmed by FT-IR and 400 MHz $^1$H-NMR. The nitrogen content is shown in Table 1, and the molecular weight and the factor (F) are shown in Table 2.
IR ($cm^{-1}$):
3355 (N-H stretching vibration), 1709 (C=O; carbonyl)
$^1$H-NMR: (400 MHz; $CDCl_3$; Internal Standard: TMS)
δ (ppm): 7.0-8.1 (Ph-H), 3.5 ($-C(CH_3)_3$), 2.1-2.4 ($Ph-CH_3$), 9.0-9.1 (-NH-)

PRODUCTION EXAMPLE 2: Production of tBOC-TDIDHBA

A solution prepared by adding 20 ml of DMAc to 17.34 g of a 50 wt % butyl acetate solution of TDI was slowly added dropwise from a dropping funnel into 30 ml of DMAc solution dissolving 4.20g (30 mmol: 1.0 equivalent) of 3,5-dihydroxybenzyl alcohol (DHBA) (reagent available from ACROS ORGANICS Co., Ltd.), and the resultant mixture was stirred at room temperature for one hour. After slowly added dropwise with 14.4 g (66 mmol) of di-tert-butyl dicarbonate and 7.2 g of triethylamine, the mixture was stirred at 60°C for 7 h. The resultant reaction solution was added to a large amount of water and the re-precipitation was repeated to obtain a white powder (tBOC-TDIDHBA composition). The white powder was purified by column chromatography using a mixed solvent of hexane/ethyl acetate = 3/4 to collect the main fraction, which was finally dried under reduced pressure to obtain 31.1 g of the aimed product (tBOC-TDIDHBA compound). The structure thereof was confirmed by FT-IR and 400 MHz $^1$H-NMR. The nitrogen content is shown in Table 1, and the molecular weight and the factor (F) are shown in Table 2.
IR($cm^{-1}$):
3355 (N-H stretching vibration), 1708 (C=O; carbonyl)
$^1$H-NMR: (400 MHz; $CDCl_3$; Internal Standard: TMS)
δ (ppm): 7.0-8.3 (Ph-H), 1.5($-C(CH_3)_3$), 2.1-2.4 ($Ph-CH_3$), 3.3 ($Ph-CH_2-O-$). 9.1-9.2 (-NH-)

PRODUCTION EXAMPLE 3: Production of tBOC-BICAP

After heating 2039 g of bisisocyanatocyclohexane (reagent available from Kanto Chemical Co., Ltd.) to 50°C under stirring, 2.2 g of a solution of tetramethylammonium 2-ethylhexanoate in ethyl cellosolve (DABCO/TMR) (available from Nippon Nyukazai Co., Ltd.) as a catalyst was added dropwise thereinto over 20 min. Thereafter, the progress of reaction was monitored by gel permeation chromatography (GPC) at 70°C under stirring. At the time when the conversion to isocyanurate reached 40%, 0.35 g of phosphoric acid (reagent available from Kanto Chemical Co., Ltd.) was added as a reaction terminator. The reaction solution was cooled to 50°C, filtered to remove the catalyst and the salts of reaction terminator, and then subjected to thin-film distillation. As a result of GPC analysis, the reaction product was confirmed to be 739 g of isocyanurate polyisocyanate derived from bisisocyanatocyclohexane (BIC) having an isocyanurate content of 99.2%. Then, BIC was made into a 71.8 wt % solution in butyl acetate.

A solution prepared by adding 5 ml of DMAc into 6.50 g of the 71.8 wt % butyl acetate solution of BIC (NCO equivalent = 324; non-volatile content = 71.8% by weight) was slowly added dropwise from a dropping funnel into 5 ml of a DMAc solution dissolving 2.18 g (20 mmol: 1.0 equivalent) of AP, and the resultant mixture was stirred at room temperature for one hour. After slowly added dropwise with 5.47 g (25 mmol) of di-tert-butyl dicarbonate and 2.83 g of triethylamine, the mixture was stirred at 60°C for 7 h. The resultant reaction solution was added to a large amount of water and the re-precipitation was repeated to obtain a white powder (tBOC-BICAP composition). The white powder was purified by column chromatography using a mixed solvent of hexane/ethyl acetate = 3/4 to collect the main fraction, which was finally dried under reduced pressure to obtain 7.26 g of the aimed product (tBOC-BICAP compound). The structure thereof was confirmed by FT-IR and 400 MHz $^1$H-NMR. The nitrogen content is shown in Table 1, and the molecular weight and the factor (F) are shown in Table 2.
IR ($cm^{-1}$):
3344 (N-H stretching vibration), 1754, 1687 (C=O; carbonyl)

$^1$H-NMR: (400 MHz; DMSO-d6; Internal Standard: TMS)

δ (ppm): 7.0-7.4 (Ph-H), 1.5 (—$C(CH_3)_3$), 1.2-2.4 (Ch-H), 3.3-3.6 (-$CH_2$-), 6.6,8.4 (-NH-) (Ch = cyclohexylene group)

PRODUCTION EXAMPLE 4: Production of tBOC-IPDIAP

A solution prepared by adding 5 ml of DMAc into 7.16 g of a 70 wt % butyl acetate solution of an isocyanurate polyisocyanate derived from isophoronediisocyanate (IPDI) (available from Degussa Corp.; NCO equivalent = 358; non-volatile content = 70% by weight) was slowly added dropwise from a dropping funnel into 5 ml of a DMAc solution dissolving 2.19 g (20 mmol: 1.0 equivalent) ofAP, and the resultant mixture was stirred at room temperature for one hour. After slowly added dropwise with 5.46 g (25 mmol) of di-tert-butyl dicarbonate and 2.83 g of triethylamine, the mixture was stirred at 60°C for 7 h. The resultant reaction solution was added to a large amount of water and the re-precipitation was repeated to obtain a white powder (tBOC-IPDIAP composition). The white powder was purified by column chromatography using a mixed solvent of hexane/ethyl acetate = 3/4 to collect the main fraction, which was finally dried under reduced pressure to obtain 7.77 g of the aimed product (tBOC-IPDIAP compound). The structure thereof was confirmed by FT-IR and 400 MHz $^1$H-NMR. The nitrogen content is shown in Table 1, and the molecular weight and the factor (F) are shown in Table 2.

IR ($cm^{-1}$):

3344 (N-H stretching vibration), 1756, 1685 (C=O; carbonyl)

$^1$H-NMR: (400 MHz; DMSO-d6; Internal Standard: TMS)

δ (ppm): 6.9-7.4 (Ph-H), 0.9-1.4 (-$CH_3$), 1.5 (-$C(CH_3)_3$), 1.0-1.6, 3.7 (Ch-H), 3.6 (-$CH_2$-), 8.4.8.5 (-NH-)

PRODUCTION EXAMPLE 5: Production of tBOC-BICAP5

The tBOC-BICAP composition (5.02 g) was purified by column chromatography using a mixed solvent of hexane/ethyl acetate = 3/8 and dried under reduced pressure to obtain 1.02 g of the aimed product having an isocyanurate structure of BIC pentamer (tBOC-BICAP5 compound). The structure thereof was confirmed by FT-IR and 400 MHz $^1$H-NMR. The nitrogen content is shown in Table 1, and the molecular weight and the factor (F) are shown in Table 2.

IR ($cm^{-1}$):

3344 (N-H stretching vibration), 1754, 1687 (C=O, carbonyl)

$^1$H-NMR: (400 MHz; DMSO-d6; Internal Standard: TMS)

δ (ppm): 7.0-7.4 (Ph-H), 1.5 (-$C(CH_3)_3$), 1.2-2.4 (Ch-H), 3.3-3.6 (-$CH_2$-), 6.6, 8.4 (-NH-) (Ch = cyclohexylene group)

PRODUCTION EXAMPLE 6: Production of tBOC-BICAP7

The tBOC-BICAP composition (15.32 g) was purifed by column chromatography using a mixed solvent of hexane/ethyl acetate = 1/4 and dried under reduced pressure to obtain 0.90 g of the aimed product having an isocyanurate structure of BIC heptamer (tBOC-BICAP7 compound). The structure thereof was confirmed by FT-IR and 400 MHz $^1$H-NMR. The nitrogen content is shown in Table 1, and the molecular weight and the factor (F) are shown in Table 2.

IR ($cm^{-1}$):

3344 (N-H stretching vibration), 1754, 1687 (C=O; carbonyl)

$^1$H-NMR: (400 MHz; DMSO-d6; Internal Standard: TMS)

δ (ppm): 7.0-7.4 (Ph-H), 1.5 (-$C(CH_3)_3$), 1.2-2.4 (Ch-H), 3.3-3.6 (-$CH_2$-), 6.6, 8.4 (-NH-) (Ch = cyclohexylene group)

PRODUCTION EXAMPLE 7: Production of Ac-TDIAA

A solution prepared by adding 5 ml of DMAc into 5.78 g of a 50 wt % butyl acetate solution of TDI was slowly added dripwise from a dropping funnel into 5 ml of a DMAc solution dissolving 1.80 g (10 mmol: 1.0 equivalent) of acetoxybenzoic acid (Ac-AA) (reagent available from Kanto Chemical Co., Ltd.), and the resultant mixture was stirred at room temperature for one hour. The resultant reaction solution was added to a large amount of water and the re-precipitation was repeated to obtain a white powder (Ac-TDIAA composition). The white powder was purified by column chromatography using a mixed solvent of hexane/ethyl acetate = 3/4 to collect the main fraction, which was finally dried under reduced pressure to obtain 2.54 g of the aimed product (Ac-TDIAA compound). The structure thereof was

confirmed by FT-IR and 400 MHz $^1$H-NMR. The nitrogen content is shown in Table 1, and the molecular weight and the factor (F) are shown in Table 2.
IR ($cm^{-1}$):
3305 (N-H stretching vibration), 1708, 1645 (C=O; carbonyl)
$^1$H-NMR: (400 MHz; DMSO-d6; Internal Standard: TMS)
δ (ppm): 6.8-8.0 (Ph-H), 2.1-2.4 (Ph-$CH_3$), 2.3 (-$CH_3$), 10.3 (-NH-)

COMPARATIVE PRODUCTION EXAMPLE 1: Production of tBOC-H-TMADHBA

Into a solution composed of 3.5 g (50 mmol) of DHBA, 6.9 g (50 mmol) of potassium carbonate (reagent available from Kanto Chemical Co., Ltd.) and 125 ml of acetone (reagent available from Kanto Chemical Co., Ltd.), was added 10.9 g (50 mmol) of di-tert-butyl dicarbonate. The resultant mixture was stirred at room temperature for 30 h. After removing solid matters from the reaction solution by filtration, the acetone was removed under reduced pressure using a rotary evaporator to obtain a colorless solution, which was dissolved in 50 ml of tert-butyl methyl ether and extracted with 50 g of a 1 M sodium hydroxide solution three times. The collected extract was washed with 50 ml of water three times, dried over sodium sulfate, and filtered. Then, the tert-butyl methyl ether was removed under reduced pressure using a rotary evaporator to obtain a white powder (tBOC-DHBA composition). The white powder was purified by column chromatography using a mixed solvent of hexane/ethyl acetate = 3/4, and dried under reduced pressure to obtain 3,5-di-tert-butoxycarbonyloxybenzyl alcohol (tBOC-DHBA compound) in a yield of 60%. The structure thereof was confirmed by FT-IR and 400 MHz $^1$H-NMR.
IR ($cm^{-1}$):
3546 (N-H stretching vibration), 1758, 1731 (C=O; carbonyl)
$^1$H-NMR: (400 MHz; DMSO-d6; Internal Standard: TMS)
δ (ppm): 7.0-7.2 (Ph-H), 1.5 (-$C(CH_3)_3$), 5.1 (Ph-$CH_2$-O-), 5.4 (-OH)

A solution prepared by adding 4 ml of methylene chloride to a mixture of 1.46 g (4.2 mmol) of tBOC-DHBA compound, 0.31 g (1.4 mmol) of H-TMA and 1.02 g (10.1 mmol) of triethylamine was added to a solution prepared by adding 6 ml of methylene chloride to 1.39 g (5.0 mmol) of 2 bromo-1-ethylpyridinium tetrafluoroborate (reagent available from Tokyo Kasei Kogyo Co., Ltd.). and the resultant mixture was stirred at 40°C for one hour. The reaction solution was dissolved in 50 ml of tert-butyl methyl ether, washed with 50-ml of water three times, dried over sodium sulfate, and then filtered. Then, the tert-butyl methyl ether was removed under reduced pressure using a rotary evaporator to obtain a white powder (tBOC-H-TMADHBA composition). The white powder was purified by column chromatography using a mixed solvent of hexane/ethyl acetate = 3/4, and dried under reduced pressure to obtain 1.60 g of the aimed product (tBOC-H-TMADHMA compound). The structure thereof was confirmed by FT-IR and 400 MHz $^1$H-NMR. The nitrogen content is shown in Table 1, and the molecular weight and the factor (F) are shown in Table 2.
IR ($cm^{-1}$):
2979 (N-H stretching vibration), 1756, 1730 (C=O; carbonyl)
$^1$H-NMR: (400 MHz; DMSO-d6; Internal Standard: TMS)
δ (ppm): 7.0-7.1 (Ph-H), 1.3-1.5 (-$C(CH_3)_3$) + (-$C_6H_3$-), 5.0-5.1 (Ph-$CH_2$-O-)

COMPARATIVE PRODUCTION EXAMPLE 2: Production of tBOC-TMADHBA

A solution prepared by adding 4 ml of methylene chloride to a mixture of 1.46 g (4.2 mmol) of tBOC-DHBA compound, 0.31 g (1.4 mmol) of TMA and 1.02 g (10.1 mmol) of triethylamine was added to a solution prepared by adding 6 ml of methylene chloride to 1.39 g (5.0 mmol) of 2-bromo-1-ethylpyridinium tetrafluoroborate, and the resultant mixture was stirred at 40°C for one hour. The reaction solution was dissolved in 50 ml of tert-butyl methyl ether, washed with 50 ml of water three times, dried over sodium sulfate, and then filtered. Then, the tert-butyl methyl ether was removed under reduced pressure using a rotary evaporator to obtain a white powder (tBOC-TMADHBA composition). The white powder was purified by column chromatography using a mixed solvent of hexane/ethyl acetate = 3/4, and dried under reduced pressure to obtain 1.60 g of the aimed product (tBOC-TMADHBA compound). The structure thereof was confirmed by FT-IR and 400 MHz $^1$H-NMR. The nitrogen content is shown in Table 1, and the molecular weight and the factor (F) are shown in Table 2.
IR ($cm^{-1}$):
2985 (N-H stretching vibration), 1756, 1729 (C=O; carbonyl)
$^1$H-NMR: (400 MHz; DMSO-d6; Internal Standard: TMS)
δ (ppm): 7.1-8.7 (Ph-H), 1.4 (-$C(CH_3)_3$), 5.3-5.4 (Ph-$CH_2$-O-)

COMPARATIVE EXAMPLE 3: Production of BCOTPB

Into a 20 wt % butyl acetate solution dissolving 3.00 g (8.5 mmol) of 1,3,-tris(4-hydroxyphenyl)benzene (available from Aldrich Chemical Company, Inc.), were slowly added dropwise 6.00 g (28 mmol) of di-tert-butyl dicarbonate and 3.01 g of triethylamine, and the resultant mixture was stirred at 60°C for 7 h. The resultant reaction solution was added to a large amount of water and the re-precipitation was repeated to obtain a white powder (BCOTPB composition). The white powder was purified by column chromatography using a mixed solvent of hexane/ethyl acetate = 3/4 and dried under reduced pressure to obtain 5.00 g of the aimed product (BCOTPB compound). The structure thereof was confirmed by FT-IR and 400 MHz $^1$H-NMR. The nitrogen content is shown in Table 1, and the molecular weight and the factor (F) are shown in Table 2.
IR ($cm^{-1}$):
1752 (C=O; carbonyl)
$^1$H-NMR; (400 MHz; $CDCl_3$; Internal Standard: TMS)
δ (ppm): 7.0-7.5 (Ph-H), 1-4 ($-C(CH_3)_3$)

COMPARATIVE EXAMPLE 4: Production of tBOC-PIAP

A solution prepared by adding 10 ml of DMAc into 7.15 g (60 mmol) of phenyl isocyanate (PI) (available from Kanto Chemical Co., Ltd.) was slowly added dropwise from a dropping funnel into a solution prepared by adding 10 ml of DMAc into 6.53 g (60 mmol) of AP, and the resultant mixture was stirred at room temperature for one hour. After slowly added dropwise with 14.4 g (66 mmol) of di-tert-butyl dicarbonate and 7.2 g of triethylamine (available from Kanto Chemical Co., Ltd.), the mixture was stirred at 60°C for 7 h. The resultant reaction solution was added to a large amount of water and the re-precipitation was repeated to obtain a white powder (tBOC-PIAP composition). The white powder was purified by column chromatography using a mixed solvent of hexane/ethyl acetate = 3/4 to collect the main fraction, which was finally dried under reduced pressure to obtain 11.00 g of the aimed product (tBOC-PIAP compound). The structure thereof was confirmed by FT-IR and 400 MHz $^1$H-NMR. The nitrogen content is shown in Table 1, and the molecular weight and the factor (F) are shown in Table 2.
IR ($cm^{-1}$):
3355 (N=H stretching vibration), 1709 (C=O; carbonyl)
$^1$H-NMR: (400 MHz; DMSO-d6; Internal Standard: TMS)
δ (ppm): 7.0-8.1 (Ph-H), 3.5 ($-C(CH_3)_3$), 2.1-2.4 ($Ph-CH_3$)

COMPARATIVE EXAMPLE 5: Production of Ac-TAPPA

A solution prepared by adding 5 ml of methylene chloride to 3.75 g (30 mmol) of triaminopyridine (TAP) (reagent available from Aldrich Chemical Company, Inc.) was slowly added dropwise from a dropping funnel into 5 ml of a methylene chloride solution dissolving 12.5 g (90 mmol) of 6-hydroxy-2-pyridinecarboxylic acid (PA) (reagent available from Aldrich Chemical Company, Inc.), 30.0 g (108 mmol) of 2-bromo-1-ethylpyridinium tetrafluoroborate and 15.0 g of triethylamine, and the resultant mixture was stirred at 40°C for 4 h. The reaction solution was dissolved in 50 ml of tert-butyl methyl ether, washed with 50 ml of water three times, dried over sodium sulfate, and then filtered. Then, the tert-butyl methyl ether was removed under reduced pressure using a rotary evaporator to obtain 2.02 g of a white powder, into which 16.41 g (75 mmol) of di-tert-butyl dicarbonate and 8.21 g of triethylamine were slowly added dropwise, and the resultant mixture was stirred at 60°C for 7 h. The resultant reaction solution was added to a large amount of water and the re-precipitation was repeated to obtain a white powder (Ac-TAPPA composition). The white powder was purified by column chromatography using a mixed solvent of hexane/ethyl acetate = 3/4 and dried under reduced pressure to obtain 1.10 g of the aimed product (Ac-TAPPA compound). The structure thereof was confirmed by FT-IR and 400 MHz $^1$H-NMR. The nitrogen content is shown in Table 1, and the molecular weight and the factor (F) are shown in Table 2.
IR ($cm^{-1}$):
3349 (N-H stretching vibration), 1645 (C=O; carbonyl)
$^1$H-NMR: (400 MHz; DMSO-d6; Internal Standard: TMS)
δ (ppm): 7.2-8.0 (Ph-H), 2.3 ($-CH_3$), 9.3 (-OH), 10.3 (-NH-)
The respective measuring methods used herein are as follows.

(1) Nitrogen Content:

Determined by CHN elemental analysis.

(2) Molecular Weight:

Calculated on a pure substance identified by IR and $^1$H-NMR.

(3) Factory (F):

Determined by calculation.

Table 1

| Resist compound | | Nitrogen content (%) | |
|---|---|---|---|
| | | found | calculated |
| Production Examples | | | |
| 1 | tBOC-TDIAP | 11.0 | 11.0 |
| 2 | tBOC-TDIDHBA | 5.9 | 5.7 |
| 3 | tBOC-BICAP | 10.4 | 10.4 |
| 4 | tBOC-IPDIAP | 9.7 | 9.7 |
| 5 | tBOC-BICAP5 | 6.0 | 6.0 |
| 6 | tBOC-BICAP7 | 6.4 | 6.4 |
| 7 | Ac-TDIAA | 12.9 | 12.9 |
| Comparative Production Examples | | | |
| 1 | tBOC-H-TMADHBA | 0.0 | 0.0 |
| 2 | tBOC-TMADHBA | 0.0 | 0.0 |
| 3 | BCOTPB | 0.0 | 0.0 |
| 4 | tBOC-PIAP | 8.4 | 8.4 |
| 5 | Ac-TAPPA | 21.1 | 21.1 |

Table 2

| Resist compound | | Molecular weight | Factor (F) |
|---|---|---|---|
| Production Examples | | | |
| 1 | tBOC-TDIAP | 1150.2 | 3.3 |
| 2 | tBOC-TDIDHBA | 1471.5 | 4.3 |
| 3 | tBOC-BICAP | 1210.4 | 3.6 |
| 4 | tBOC-IPDIAP | 1294.6 | 3.6 |
| 5 | tBOC-BICAP5 | 2332.6 | 4.2 |
| 6 | tSOC-BICAP7 | 3061.5 | 4.1 |
| 7 | Ac-TDIAA | 976.0 | 3.0 |
| Comparative Production Examples | | | |
| 1 | tBOC-H-TMADHBA | 1177.2 | 4.3 |
| 2 | tBOC-TMADHBA | 1183.3 | 4.5 |
| 3 | BCOTPB | 654.8 | 3.0 |
| 4 | tBOC-PIAP | 328.5 | 3.1 |
| 5 | Ac-TAPPA | 530.5 | 3.4 |

FILM-FORMATION TEST

EXAMPLES 1-7 and COMPARATIVE EXAMPLES 1-5

The resist compound (0.5 g) each produced in Production Examples 1 to 7 and Comparative Production Examples 1 to 5, and the acid generator shown in Table 3 (at blending ratio shown In Table 3) were dissolved in the

solvent (4.5 g) shown in Table 3 to prepare each uniform solution. The solution was filtered through a Teflon membrane filter having a pore size of 0.2 μm to prepare a resist solution. The resist solution was applied to the substrate shown in Table 4 by a rotational coating method to form a resist film. The film-forming property of the resist film is shown in Table 4. The film-forming property was evaluated by the following method.

Evaluation of Film-Forming Property

A 10 x 10 mm square resist film was divided into 100 sections, and the number of the sections uncoated with the resist film and the number of crystallized sections were counted to evaluate the film-forming property according to the following ratings:

Zero: + (good)
One or more sections: - (poor)

Table 3

| | | | Acid generator | |
|---|---|---|---|---|
| Resist compound | | Solvent | Kind | Amount blended (wt%) |
| Examples | | | | |
| 1-1 | tBOC-TDIAP | PGME | DNQ | 5 |
| 1-2 | tBOC-TDIAP | PGME | WPI007 | 5 |
| 1-3 | tBOC-TDIAP | PGME | WPAG596 | 5 |
| 2-1 | tBOC-TDIDHBA | PGME | DNQ | 5 |
| 2-2 | tBOC-TDIDHBA | PGME | WPI007 | 5 |
| 2-3 | tBOC-TDIDHBA | PGME | WPAG596 | 5 |
| 3 | tBOC-BICAP | EL/PGMEA | DNQ | 5 |
| 4 | tBOC-IPDIAP | EL/PGMEA | DNQ | 5 |
| 5 | tBOC-BICAP5 | EL/PGMEA | DNQ | 5 |
| 6 | tBOC-BICAP7 | EL/PGMEA | DNQ | 5 |
| 7 | Ac-TDIAA | PGME | DNQ | 5 |
| Comparative Examples | | | | |
| 1 | tBOC-H-TMADHBA | EL/PGMEA | DNQ | 5 |
| 2 | tBOC-TMADHBA | EL/PGMEA | DNQ | 5 |
| 3 | BCOTPB | EL/PGMEA | WPI007 | 3 |
| 4 | tBOC-PIAP | PGME | DNQ | 5 |
| 5 | Ac-TAPPA | EL/PGMEA | WPI007 | 3 |

Solvent
PGME: Propylene glycol methyl ether
EL: Ethyl lactate
PGMEA: Propylene glycol monoethyl acetate
Acid Generator
DNQ: Sodium 1,2-naphthoquinone-2-diazido-5-sulfonate
WPI007: Diphenyliodonium trifluorosulfonate
WPAG596: Diphenylxanthone-2-yl-sulfonium hexafluorophosphate

Table 4

| Resist compound | | Film-forming property | | | |
|---|---|---|---|---|---|
| | | n-Si substrate Surface-untreated | n-Si substrate Surface-treated* | n-Si substrate Hydrofluoric acid-treated | GaAs substrate Surface-untreated |
| Examples | | | | | |
| 1-1 | tBOC-TDIAP | + | + | + | + |
| 1-2 | tBOC-TDIAP | + | + | + | + |
| 1-3 | tBOC-TDIAP | + | + | + | + |
| 2-1 | tBOC-TDIDHBA | + | + | + | + |
| 2-2 | tBOC-TDIDHBA | + | + | + | + |
| 2-3 | tBOC-TDIDHBA | + | + | + | + |
| 3 | tBOC-BICAP | + | + | + | + |
| 4 | tBOC-IPDIAP | + | + | + | + |
| 5 | tBOC-BICAP5 | + | + | + | + |
| 6 | tBOC-BICAP7 | + | + | + | + |
| 7 | Ac-TDIAA | + | + | + | + |
| Comparative Examples | | | | | |
| 1 | tBOC-H-TMADHBA | - | + | + | + |
| 2 | tBOC-TMADHBA | - | + | + | + |
| 3 | BCOTPB | - | - | - | - |
| 4 | tBOC-PIAP | - | - | - | - |
| 5 | Ac-TAPPA | + | + | + | + |

*Surface-treating agent:1,1,1,3,3,3-hexamethyldisilazane

FORMATION OF RESIST PATTERNS

EXAMPLES 8-14 and COMPARATIVE EXAMPLES 6-8

A uniform solution was prepared by mixing 0.5 g of the resist compound respectively produced in Production Examples 1 to 7 and Comparative Production Examples 1, 2 and 5, the acid generator shown in Table 3 (at blending ratio shown in Table 3) and 4.5 g of the solvent shown in Table 3. The solution was filtered through a Teflon membrane filter having a pore size of 0.2 µm to prepare a resist solution. The resultant resist solution was applied onto a clean silicon wafer by a rotational coating method, and then subjected to pro-exposure baking (PB) in an oven under conditions shown in Table 5 to form a resist film having a thickness of 0.2 µm. The resist film was exposed to i-rays of a wavelength of 365 nm under conditions shown in Table 5. Then, the resist film was subjected to post-exposure baking in an oven under conditions shown in Table 6 and developed at 23°C by a standing method under conditions shown in Table 6. Thereafter, the developed resist film was washed with water for 30 s and dried to form positive resist patterns. The formed resist patterns were evaluated by the following methods.

(1)5 µm L & S

The developed resist patterns were observed by an optical microscope to confirm whether 5 µm line-and-space patterns were formed, and evaluated according to the following ratings:

Confirmed; +
Not confirmed: -

A scanning electron microphotograph of the resist patterns obtained in Example 9 is shown in Fig. 1, in which dark portions are non-exposed areas containing residual resist and light portions are exposed areas from which resist was removed.

(2) Adhesion to Substrate

A 10 x 10 mm square resist film was divided into 100 sections, and the number of the sections from which the resist film was peeled off were counted to evaluate the adhesion to substrate according to the following ratings:

Zero: + (good)
One or more sections: - (poor)

(3) Etching Resistance

An aluminum thin film (alloyed with Si and Cu) having a thickness of about 20 nm was vapor-deposited on a silicon wafer using a high-rate sputtering apparatus "SH-550 Model" available from ULVAC, INC.

Etching solution: 0.1 N sodium hydroxide aqueous solution
Etching time: 3 min

After etched under the above conditions, the treated substrate was washed with pure water, and the remaining resist was dissolved away by acetone. The etch patterns formed were observed under an optical microscope to visually evaluate the shape thereof.

Good: +
Poor: -

The evaluation results are shown in Table 7.

Table 5

| Resist compound | | Pre-expossure baking | | Exposure |
|---|---|---|---|---|
| | | Temperature (°C) | Time (sec) | (mJ/cm$^2$) |
| Examples | | | | |
| 8 | tBOC-TDIAP | 110 | 600 | 110 |
| 9 | tBOC-TDIDHBA | 110 | 600 | 100 |
| 10 | tBOC-BICAP | 90 | 600 | 1320 |
| 11 | tBOC-IPDIAP | 90 | 600 | 1320 |
| 12 | tBOC-BICAP5 | 100 | 600 | 1320 |
| 13 | tBOC-BICAP7 | 100 | 600 | 44000 |
| 14 | Ac-TDIAA | 100 | 600 | 44000 |
| Comparative Examples | | | | |
| 6 | tBOC-H-TMADHBA | 100 | 600 | 2640 |
| 7 | tBOC-TMADHBA | 90 | 600 | 1320 |
| 8 | Ac-TAPPA | 100 | 600 | 1320 |

Table 6

| Resist compound | | Poste-exposure baking | | Developing conditions | |
|---|---|---|---|---|---|
| | | Temp. (°C) | Time (see) | Solution | Time (sec) |
| Examples | | | | | |
| 8 | tBOC-TDIAP | 135 | 600 | TMAH | 60 |
| 9 | tBOC-TDIDHBA | 120 | 600 | TMAH | 60 |
| 10 | TBOC-BICAP | 140 | 600 | TMAH/IPA | 60 |
| 11 | tBOC-IPDIAP | 150 | 600 | TMAH/IPA | 60 |
| 12 | tBOC-BICAP5 | 145 | 600 | TMAH | 60 |

Table 6 (continued)

| Resist compound | | Poste-exposure baking | | Developing conditions | |
|---|---|---|---|---|---|
| | | Temp. (°C) | Time (see) | Solution | Time (sec) |
| Examples | | | | | |
| 13 | tBOC-BICAP7 | 150 | 600 | TMAH | 60 |
| 14 | Ac-TDIAA | 250 | 600 | TMAH/IPA | 60 |
| Comparative Examples | | | | | |
| 6 | tBOC-H-TMADHBA | 135 | 600 | TMAH | 60 |
| 7 | tBOC-TMADHBA | 95 | 600 | TMAH | 60 |
| 8 | Ac-TAPPA | 145 | 600 | TMAH | 60 |

Developing Solution
TMAH: 2.38 wt % aqueous solution of tetramethylammonium hydroxide
TMAH/IPA: Mixed solution of 2.38 wt % aqueous solution of tetramethylammonium hydroxide and isopropyl alcohol

Table 7

| Resist compound | | 5µmL&S | Adhesion to substrate | Etching resistance |
|---|---|---|---|---|
| Examples | | | | |
| 8 | tBOC-TDIAP | + | + | + |
| 9 | tBOC-TDIDHBA | + | + | + |
| 10 | tBOC-BICAP | + | + | + |
| 11 | tBOC-IPDIAP | + | + | + |
| 12 | tBOC-BICAP5 | + | + | + |
| 13 | tBOC-BICAP7 | + | + | + |
| 14 | Ac-TDIAA | + | + | + |
| Comparative Examples | | | | |
| 6 | tBOC-H-TMADHBA | - | - | n.d. |
| 7 | tBOC-TMADHBA | - | - | n.d. |
| 8 | Ac-TAPPA | - | + | n.d. |

n.d.: Not determined.

In Examples 8 to 13, 5 µm L & S patterns having a good pattern shape were obtained, whereas in Comparative Examples 6 to 8, no 5 µm L & S patterns having a good pattern shape were obtained.

ELECTRON BEAM IRRADIATION TEST

EXAMPLE 15

Each solution formulated in Example 1-1 or 2-2 was filtered through a Teflon membrane filter having a pore size of 0.2 µm to prepare a resist solution. The resist solution was applied onto a clean silicon wafer by a rotational coating method and then subjected to pre-exposure baking in an oven under conditions shown in Table 5 to form a resist film having a thickness of 0.2 µm. The resist, film was exposed to electron beams at a current of 200 pA and an exposure of 10 $\mu C/cm^2$ using an electron beam exposure apparatus "JBX-5FE Model" available from JEOL Ltd. Then, the exposed resist film was subjected to post-exposure baking in an oven under conditions shown in Table 6, and then developed at 23°C by a standing method under conditions shown in Table 6. Thereafter, the developed resist film was washed with water for 30 sec and then dried to form positive resist patterns.

## Claims

1. A resist composition comprising at least one resist compound satisfying all the following requirements a) to f):

   a) containing at least one acid-dissociating functional group in molecule thereof,
   b) containing at least one kind of functional group selected from the group consisting of urea group, urethane group, amido group and imido group in a molecule thereof,
   c) having a molecular weight of 500 to 5,000,
   d) having a branched structure,
   e) satisfying the formula: $3 \leq F \leq 5$, wherein F is represented by (number of total atoms)/(number of total carbon atoms - number of total oxygen atoms), and
   f) having a nitrogen content of 1 to 20% by mass; and

   at least one acid or base generator capable of directly or indirectly generating an acid or a base by exposure to radiation selected from the group consisting of visible lights, ultraviolet rays, excimer lasers, electron beams, X-rays and ion beams.

2. The resist composition according to claim 1, wherein the branched structure is a chemical structure satisfying at least one of the following requirements (1) to (4):

   (1) having a tertiary carbon atom or a tertiary nitrogen atom which is not included in a cyclic structure;
   (2) having a quaternary carbon atom;
   (3) having at least one aromatic ring or aliphatic ring having three or more substituent groups; and
   (4) having a tertiary phosphorus atom.

3. The resist composition according to claim 1 or 2, wherein the resist compound satisfying all the requirements a) to e) has at least one acid-dissociating functional group in each of branched molecular chains thereof, the branched molecular chains each having at least one functional group selected from the group consisting of urea group, urethane group, amido group and imido group.

4. The resist composition according to any one of claims 1 to 3,
   wherein the resist compound is represented by the formula (1):

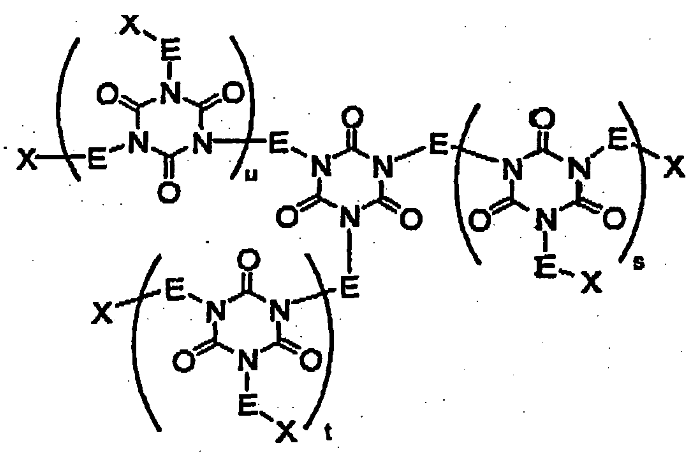

(1)

   wherein groups X are each independently hydrogen or a group represented by the following formulae (I) to (III); Groups E are each independently $C_1$ to $C_{12}$ divalent acyclic hydrocarbon group, divalent cyclic hydrocarbon group or substituted alkylene group; and s, t and u are each independently integer of 0 to 3, with the proviso that at least three of the groups X are represented by the formulae (I) to (III),
   the formulae (I) to (III) being

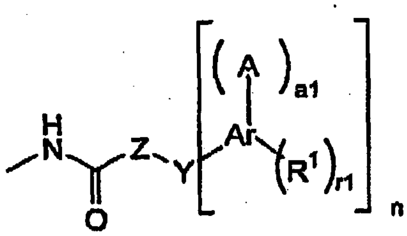 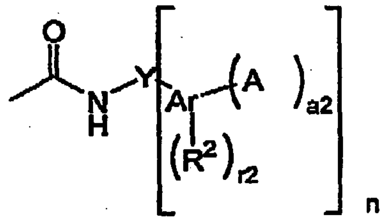 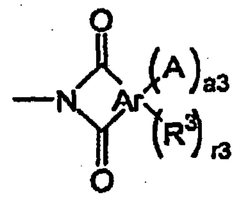

(I) (II) (III)

wherein $R^1$ to $R^3$ are each independently hydrogen or a substituent group selected from the group consisting of $C_1$ to $C_{12}$ linear hydrocarbon group, cyclic hydrocarbon group, alkoxy group and 1-branched alkyl group;

groups A are each independently hydrogen or a group represented by the formulae (IV) to (VIII):

$$—OR^4 \quad \text{(IV)}$$

$$—SR^5 \quad \text{(V)}$$

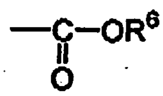 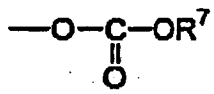 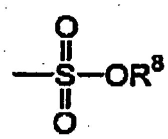

(VI) (VII) (VIII)

wherein $R^6$ and $R^8$ are each independently hydrogen or a substituent group selected from the group consisting of $C_1$ to $C_{12}$ linear hydrocarbon group, cyclic hydrocarbon group, alkoxy group and 1-branched alkyl group, $R^4$, $R^6$ and $R^7$ are each independently hydrogen or a substituent group selected from the group consisting of substituted methyl groups, 1-substituted ethyl groups, 1-substituted n-propyl groups, 1-branched alkyl groups, silyl groups, germyl groups, acyl groups, alkoxycarbonyl groups, 1-substituted alkoxymethyl groups and cyclic groups, and at least one of $R^4$ to $R^8$ is a characteristic group other than hydrogen, with the proviso that at least one of the groups A is represented by the formulae (IV) to (VIII);

groups Ar are each independently $C_6$ to $C_{12}$ aromatic hydrocarbon group;

Y is independently $C_1$ to $C_{12}$ divalent acyclic hydrocarbon group, divalent cyclic hydrocarbon group, substituted alkylene group or single bond;

Z is independently single bond or substituent group selected from the group consisting of -O-, -S- and -NH-;

a1 to a3 are each independently integer of 1 to 9, and r1 to r3 are each independently integer of 0 to 8, satisfying the formulae: $a1 + r1 \leq 9$, $a2 + r2 \leq 9$ and $a3 + r3 \leq 8$; and

n is integer of 1 to 5.

**5.** The resist composition according to any one of claims 1 to 4, wherein the resist compound has a molecular weight of 600 to 3,000 and a nitrogen content of 2 to 15% by mass.

**6.** The resist composition according to any one of claims 1 to 5,
wherein the resist compound is represented by the formulae (2) to (4):

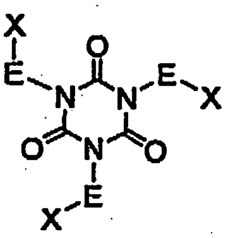

(2)

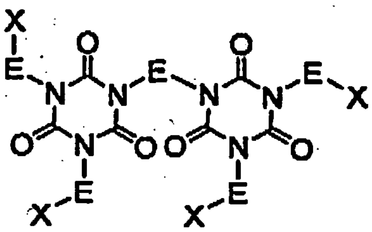

(3)

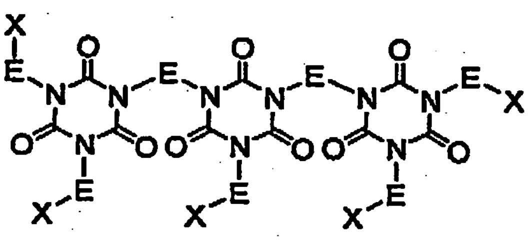

(4)

wherein groups X and groups E are the same as defined in claim 4.

**7.** The resist composition according to any one of claims 4 to 6, wherein the groups X in the formulae (1) to (4) are represented by the formulae (IX) to (XI):

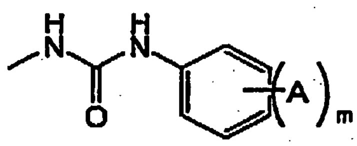

(IX)

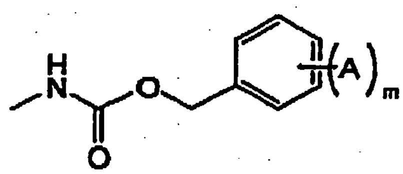

(X)

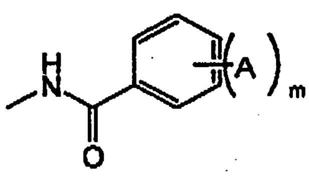

(XI)

wherein groups A are the same as defined in claim 4 and m is 1 or 2.

**8.** The resist composition according to any one of claims 4 to 7, wherein at least one of the groups A in the formulae (I) to (III) and (IX) to (XI) is represented by the formulae (XII) to (XV):

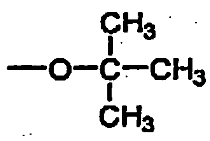

(XII)

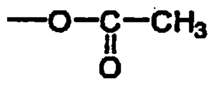

(XIII)

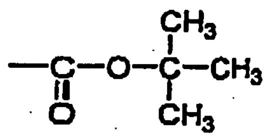

(XIV)

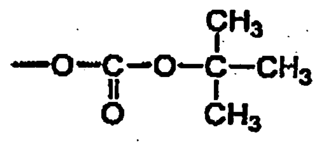

(XV)

**9.** The resist composition according to any one of claims 1 to 8, wherein the resist compound is produced from at least one polyisocyanate compound having three or more isocyanate groups.

**10.** The resist composition according to claim 9, wherein the polyisocyanate compound is at least one compound selected from the group consisting of isocyanurates, biuret derivatives, allophanate derivatives, urethane derivatives, oligomers of isocyanatophenylmethane and triisocyanates,

the isocyanurates, biuret derivatives, allophanate derivatives and urethane derivatives being derived from at least one diisocyanate compound selected from the group consisting of tolylene diisocyanate, bis(isocyanatophenyl)methane, bis(isocyanatocyclohexyl)methane, phenylene diisocyanate, cyclohexane diisocyanate, isophorone diisocyanate, hexamethylene diisocyanate, bis(isocyanatomethyl)cyclohexane, m-xylene diisocyanate, norbornane diisocyanate, tolidine diisocyanate, naphthalene diisocyanate, lysine diisocyanate, tetramethylxylene diisocyanate and trimethylhexamethylene diisocyanate, and

the triisocyanate being selected from the group consisting of tris(isocyanatophenyl)methane, tris(isocyanatophenyl) thiophosphate, mesitylene triisocyanate, triisocyanatobenzene, lysine ester triisocyanate, 1,6,11-undecane triisocyanate, 1,8-diisocyanato-4-isocyanatomethyloctane, 1,3,6-hexamethylene triisocyanate and bicycloheptane triisocyanate.

**11.** The resist composition according to any one of claims 1 to 10, wherein the composition contains two or more kinds of the resist compounds.

**12.** The resist composition according to any one of claims 4 to 11, wherein a part of the resist compounds is a resist compound wherein all of $R^4$ to $R^8$ in the formulae (IV) to (VIII) are hydrogen.

**13.** The resist composition according to any one of claims 1 to 12, further comprising a resin that is insoluble or hardly soluble in an aqueous alkali solution, but is rendered soluble therein by an action of an acid.

**14.** A resist substrate comprising a substrate and a resist film formed on the substrate which is made of the resist composition as defined in any one of claims 1 to 13.

**15.** A patterned resist substrate produced by patterning the resist film as defined in claim 14.

**16.** A process for forming resist patterns, comprising the steps of:

forming a resist film on a substrate by applying the resist composition as defined in any one of claims 1 to 13 to the substrate;
heat-treating the resist film;
exposing the heat-treated resist film by irradiating it with radiation selected from the group consisting of visible lights, ultraviolet rays, excimer lasers, electron beams, X-rays and ion beams, optionally followed by a heat-treatment of the exposed resist film; and
developing the exposed resist film with a developing solution.

**17.** A process for producing a patterned wiring board, comprising the steps of as defined in claim 16 and a subsequent step of etching.

**18.** A patterned wiring board produced by the process as defined in claim 17.

FIG. 1